# EUROPÄISCHE PATENTSCHRIFT

(11) **EP 3 981 228 B1**
(45) Veröffentlichungstag und Bekanntmachung des Hinweises auf die Patenterteilung: **16.04.2025**
(21) Anmeldenummer: 20731024.4
(22) Anmeldetag: 03.06.2020
(51) Int. Cl.: H05K 7/14, E04H 5/02

(54) **RECHENZENTRUM-MODUL UND VERFAHREN**
COMPUTING CENTRE MODULE AND METHOD
MODULE CENTRE DE CALCUL ET PROCÉDÉ

(30) Priorität: 05.06.2019 DE 102019115126
(43) Veröffentlichungstag der Anmeldung: 13.04.2022
(73) Patentinhaber: WAIYS GmbH, 01099 Dresden (DE)
(72) Erfinder: STRECH, Andreas, 01099 Dresden (DE)
(74) Vertreter: Viering, Jentschura & Partner mbB Patent- und Rechtsanwälte
(86) Internationale Anmeldenummer: PCT/EP2020/065320
(87) Internationale Veröffentlichungsnummer: WO 2020/245176

(56) Entgegenhaltungen:
- EP-A1- 2 941 110
- DE-A1- 102011 054 704

## Beschreibung

Verschiedene Ausführungsbeispiele betreffen ein Rechenzentrum-Modul und ein Verfahren.

Um kontinuierlichem Wachstum Rechnung zu tragen, sind in den letzten Jahren Container-Rechenzentren bekannt geworden, bei denen die einzelnen Komponenten eines Rechenzentrums in einem transportablen Container angeordnet werden. Solche Container können von Herstellern ab Werk vorgefertigt und vorinstalliert werden und ermöglichen dadurch einen effizienten modularen Aufbau von größeren Rechenzentren an einem beliebigen Standort.

Herkömmlich wird das Container-Rechenzentrum vor Ort aufgebaut, zusammengefügt und dessen Komponenten nachfolgend miteinander verkabelt. Bei der Zusammenstellung und Verkabelung der Komponenten wird häufig ein Augenmerk auf die Ausfallsicherheit des gesamten Container-Rechenzentrums gelegt, da die Ausfallsicherheit maßgeblich für eine Vielzahl von Dienstleistungen sein kann, die das Container-Rechenzentrum bereitstellen könnte. Die Prüfung der tatsächlichen Ausfallsicherheit erfolgt daher erst, wenn das Container-Rechenzentrum als Ganzes vollständig aufgebaut und betriebsbereit ist. Das Ergebnis der Prüfung wird nachfolgend klassifiziert und dem Container-Rechenzentrum zertifiziert (auch als Rechenzentrumszertifizierung bezeichnet). Veränderungen an dem Container-Rechenzentrum können aber unter Umständen eine erneute Rechenzentrumszertifizierung erfordern.

EP 2 941 110 A1 offenbart ein System zur Bereitstellung von Rechnerkapazität umfassend ein Basismodul und zwei oder mehr mit dem Basismodul gekoppelte Rippenmodule.

DE 10 2011 054704 A1 zeigt ein Rechenzentrum mit Serverzellen zur Aufnahme eines oder mehrerer Server.

Gemäß verschiedenen Ausführungsformen wurde anschaulich erkannt, dass es die Rechenzentrumszertifizierung ermöglicht, logistisch eigenständige Komponenten des Container-Rechenzentrums innerhalb eines Containers anzuordnen und für jeden Container einzeln im Vorfeld zu zertifizieren (auch als Vorzertifizierung bezeichnet). Mit anderen Worten kann der die Komponente beinhaltende Container einzeln hinsichtlich seines körperlichen Aufbaus auf seiner Ausfallsicherheit geprüft werden und somit eine Vorzertifizierung erhalten, noch bevor das Rechenzentrum vollständig aufgebaut ist oder noch bevor der Container überhaupt zum endgültigen Standort transportiert wird.

Gemäß verschiedenen Ausführungsformen werden mehrere einzeln vorzertifizierte Container bereitgestellt, die zu einem Rechenzentrum-Modul zusammengefügt werden, ohne deren Vorzertifizierung zu beeinflussen. Somit ist es möglich, die einzeln vorzertifizierten Container schnellstmöglich und mit hoher Ausfallsicherheit in Betrieb zu nehmen. Beispielsweise kann die Verwendung der einzeln vorzertifizierten Container den Aufbau des Rechenzentrums bzw. dessen Rechenzentrumszertifizierung beschleunigen und/oder vereinfachen (z.B. vergünstigen) und damit der steigenden Nachfrage nach verkürzten Zeiten von Planung bis zur Inbetriebnahme nachgekommen werden.

Verschiedene Verfügbarkeitsklassen 1 bis 4 verlangen bestimmte Anordnungen und Dopplungen (Redundanzen) von typischen Komponenten und Versorgungswegen der Gewerke Strom, Netzwerk bzw. Internet für die Medienversorgung und die Kühlung als Abwärme-Entsorgung. Darüber hinaus gibt es auch bauliche Anforderungen (z.B. Anforderungen an die Widerstandsklasse gegen Einbruch bei den Türen oder Brand- und Rauchschutzanforderungen, Platzbedarf für Wartung und Instanthaltung) je Verfügbarkeitsklasse. Den Verfügbarkeitsklassen sind durchschnittlich zu erwartende Verfügbarkeiten der IT-Komponenten (Informationstechnik-Komponenten) in Prozent je Betriebsjahr zugeordnet.

Mit einem Rechenzentrum bzw. einer Entwicklung für die Verfügbarkeitsklasse 3 lassen sich durch Weglassen oder Nichtbenutzung von Komponenten auch die Verfügbarkeitsklassen 2 oder 1 erfüllen.

Es wird klar, dass mit einer Entwicklung einer flexiblen Modul-Plattform, die höchstmögliche Verfügbarkeit anstrebt und die möglichst viele Anwendungsfälle abdeckt, Kostenvorteile erzielt werden können und die Idee und die damit verbundene geistige Arbeit vor Nachahmung geschützt werden muss, um sie einer Serien-Produktion überführen zu können.

Gemäß verschiedenen Ausführungsformen wird eine Konfiguration für das Rechenzentrum-Modul bzw. das Verfahren bereitgestellt, die keine Einbauten in den Containerwänden und Türen vorsieht und die Medien-Zuführung und Medien-Abführung und Luftöffnungen und eine Zutritts- und Einbringtür lediglich über eine doppelte Wand hinter den Türflügeln des Containers an der Stirnseite bietet. Denn dadurch wird ein vereinfachter internationaler Transport und Einbruchsschutz erreicht, aber vor allem auch eine 3-seitige Skalierungsmöglichkeit in x-, y- und z-Richtung.

Anschaulich wird jeder einzeln vorzertifizierte Container derart bereitgestellt, dass dessen Ankopplung an den Rest des Rechenzentrums keine Modifikationen an denjenigen Bestandteilen des Containers erfordert, welche die Anforderungen an die Vorzertifizierung erfüllen. Somit kann jeder einzeln vorzertifizierte Container "wie er ist" dem Rechenzentrum hinzugefügt, möglicherweise innerhalb dessen verlagert, oder von dem Rechenzentrum entfernt werden (z.B. für einen Austausch), ohne die Rechenzentrumszertifizierung des Rechenzentrums zu beeinflussen. Ferner kann die Skalierbarkeit zu größeren Rechenzentren modulweise erfolgen und der internationale Transport der Container vereinfacht werden.

Beispielsweise können mehrere einzeln vorzertifizierte Container (z.B. so genannte 20ft-Container) der gleichen Bauweise, die zueinander symmetrisch eingerichtet sind, für den Aufbau eines Verbunds (z.B. mit 1,0 Megawatt oder mehr) verwendet werden, der als Rechenzentrum-Modul dient und optional horizontal und/oder vertikal skalierbar ist. Es kann anstatt zweier zueinander symmetrisch eingerichtet Container aber auch ein größerer Container (z.B. ein so genannter 40ft-Container) verwendet werden, der zwei zueinander symmetrisch eingerichtete Segmente aufweist.

Gemäß verschiedenen Ausführungsformen wird ein Rechenzentrum-modul nach Anspruch 1 dargestellt.

Es zeigen
Figur 1 ein Verfahren gemäß verschiedenen Ausführungsformen in einem schematischen Ablaufdiagram;
Figuren 2 und 3 jeweils eine Versorgungskette gemäß verschiedenen Ausführungsformen in einem schematischen Versorgungsdiagram;
Figuren 4 und 5 jeweils ein Rechenzentrum-Modul (z.B. ein 40ft-Rechenzentrum-Modul) gemäß verschiedenen Ausführungsformen in einem schematischen Versorgungsdiagram;
Figur 6 ein Rechenzentrum gemäß verschiedenen Ausführungsformen in einem schematischen Versorgungsdiagram;
Figur 7 einen vorzertifizierten Container gemäß verschiedenen Ausführungsformen in einem schematischen Aufbaudiagram;
Figur 8 mehrere Verfügbarkeitsklassen gemäß verschiedenen Ausführungsformen in einem schematischen Diagramm; und
Figuren 9, 10 und 11 jeweils eine Versorgungskette gemäß verschiedenen Ausführungsformen in einem schematischen Versorgungsdiagram.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung (z.B. ohmsch und/oder elektrisch leitfähig, z.B. einer elektrisch leitfähigen Verbindung), eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Gemäß verschiedenen Ausführungsformen kann der Begriff "gekoppelt" oder "Kopplung" im Sinne einer (z.B. mechanischen, hydrostatischen, thermischen und/oder elektrischen, aber auch datentechnischen), z.B. direkten oder indirekten, Verbindung zu einer Wechselwirkungskette verstanden werden. Mehrere miteinander gekoppelte Elemente können beispielsweise entlang der Wechselwirkungskette (z.B. kommunikativ) miteinander wechselwirken, so dass zwischen diesen ein Medium (z.B. eine Information, Energie und/oder Materie) ausgetauscht werden kann. Beispielsweise können zwei miteinander gekoppelte Elemente eine Wechselwirkung miteinander austauschen, z.B. eine mechanische, hydrostatische, thermische und/oder elektrische, aber auch datentechnische Wechselwirkung. Gemäß verschiedenen Ausführungsformen kann "gekuppelt" im Sinne einer mechanischen (z.B. körperlichen bzw. physikalischen) Kopplung verstanden werden, z.B. mittels eines direkten körperlichen Kontakts. Eine Kupplung kann eingerichtet sein, eine mechanische Wechselwirkung (z.B. Kraft, Drehmoment, etc.) zu übertragen.

Gemäß verschiedenen Ausführungsformen wird ein ISO-Container (z.B. ein 20ft-Container) mit drei zu öffnenden Seitenwänden (auch als Loswände bezeichnet), ein so genannter "3-Side-Door-Container", bereitgestellt als Transporteinheit und Montagemodul. Die Außenhülle des ISO-Containers kann unverändert sein (d.h. es sind beispielsweise keine Anschlüsse an den Außenwänden des Containers zumindest auf zwei oder drei Seiten), so dass dieser seine CSC-Zertifizierung (COC - "Convention for Safe Containers") behalten hat, und somit international transportierbar und zusätzlich unauffällig ist (z.B. keine Rückschlüsse auf seinen Inhalt nahe legt). Erreicht wird dies beispielsweise mittels mehrerer Zwischenwände (z.B. innere Wände) an den beiden Stirnseiten des Containers, die hinter den Loswänden (z.B. Flügeltüren aufweisend) angeordnet sind und eine Sicherheitstür mit Zutrittskontrolle und ferner Flanschanschlüsse tragen. Zwei 20ft-Container (20-Fuß-Container) können beispielsweise an ihren Stirnseiten zu einem Containerpaar ersten Typs zusammengefügt werden und so eine 40 Fuß (ungefähr 12,2 Meter) lange Einheit bilden. Zwei 20ft-Container können alternativ oder zusätzlich auch an ihren Längsseiten zu einem Containerpaar zweiten Typs zusammengefügt werden, und so einen gemeinsamen Mittelgang bilden. Beispielsweise können zwei Containerpaare gleichen Typs auf diese Weise zu einem platzsparenden und funktionellen Verbund zusammengefügt werden. Die Container jedes Containerpaars können zueinander gespiegelt eingerichtet sein. Es können aber auch andere Container, z.B. 40-ft-Container oder nicht-ISO-Container, verwendet werden.

Auf diese Art können zusammenhängende Rechenzentrum-Module, z.B. mit einer elektrischen Leistung von 1 MW (Megawatt) oder mehr, bereitgestellt werden, welche beispielsweise ein oder mehr als ein Containerpaar (z.B. gleichen Typs) aufweisen. Optional kann durch Übereinanderstellen von mehreren Rechenzentrum-Modulen eine vertikale Skalierung erreicht werden.

Verschiedene Ausführungsbeispiele stellen einen Container bereit, der beispielsweise mit einer Rechenanlage (z.B. einen Computer, Server oder mehrere Prozessorracks aufweisend) bestückt zum modularen Aufbau eines Hochleistungsrechenzentrums eingerichtet sein kann. Ein Effekt der Containerform ist, dass ein aus solchen Containern gebildetes Rechenzentrum modular erweitert werden kann, und dass beispielsweise jeder einzelne Container ab Werk vom Hersteller vorgefertigt und hinsichtlich einer Ausfallsicherheit der Rechenanlage vorzertifiziert werden kann.

Ein Effekt der Vorzertifizierung ist, dass die Container nach ihrem Transport an den Standort des Rechenzentrums, nicht mehr zertifiziert werden müssen. Dies ermöglicht es, das Rechenzentrum schneller und mit weniger Aufwand am Zielort in Betrieb zu nehmen.

Der oder jeder Container (z.B. ein ISO-Container) kann beispielsweise im Einklang mit der ISO Norm 668 ausgebildet sein oder werden. Dies hat die Wirkung, dass hierbei ein Transport der Container auf Schiffen, Bahnen und Lastkraftwagen standardisiert und damit einfach möglich ist. In verschiedenen Ausführungsformen kann der Container eine äußere Länge von 13.716 m (45ft), 12.192 m (40ft, z.B. als Standardcontainer oder Seecontainer), 9.125 m (30ft), 6.058 m (20ft, z.B. als Standardcontainer oder Seecontainer), 2.991 m (10ft), 2.438 m (8ft) oder 1.968 m (6ft), eine äußere Höhe von 2.591 m (z.B. als Standardcontainer) oder 2.896 m (auch als High-Cube-Container bezeichnet), und eine äußere Breite von 2.438 m aufweisen. Beispielsweise hat ein so genannter 20ft-Container eine äußere Länge von 6.058 m, eine äußere Höhe von 2.591 m und eine äußere Breite von 2.438 m. Ein so genannter 40ft-Container (z.B. 40ft-HC-Container) hat eine äußere Länge von 12.192 m, eine äußere Höhe von 2.896 m und eine äußere Breite von 2.438 m. In einem Beispiel kann der Container eine äußere Dimension (Länge x Breite x Höhe) von 6.058 m x 2.438 m x 2.896 m haben. Der Container kann eine innere Dimension (Länge x Breite x Höhe des Inneren) von 5.853 m x 2.342 m x 2.697 m haben.

In einer Ausführungsform ist jede im Wesentlichen vollständig zu öffnende Seitenwand (auch als Loswand bezeichnet) des Containers als mehrflüglige, faltbare oder demontierbare Wand ausgebildet. Alternativ oder zusätzlich kann die Loswand so ausgebildet sein, dass sie im Einklang mit der ISO Norm 668 wieder verschlossen werden kann, und/oder dass der Container nicht von anderen Containern unterschieden werden kann. So kann in dieser Ausgestaltung ein Versand des Containers mit üblichen Speditionen und Versandwegen in einfacher Weise mittels Lastkraftwagen, Zügen und Schiffen ermöglicht werden. Die oder jede Loswand kann beispielsweise formschlüssig mit einem Gehäuse des Containers verbundene Wandelemente aufweisen oder daraus gebildet sein, z.B. mittels eines Lagers, mittels Stiften und/oder Schrauben verbunden.

Die Rechenanlage des oder jedes Containers weist eine oder mehr als eine Recheneinheit auf, die beispielsweise zum hochdichten Aufnehmen von einer Vielzahl von Prozessoren und/oder Speichermedien eingerichtet ist. Dabei können Prozessoren, beispielsweise Serverprozessoren (CPUs), Grafikkartenprozessoren (GPUs), Kryptoprozessoren, ASICs, FPGA's, TPU (tensor processing unit), oder Mining Hardware für Kryptowährungen sein. Speichermedien können mechanische Festplatten (HDDs) oder Halbleiter-Speicher (SSDs) sein.

In verschiedenen Ausführungsformen kann der Container mehrere Versorgungspfade mit einer Einspeisungsschnittstelle aufweisen, die eingerichtet ist, dem Container von außerhalb zumindest ein Medium zuzuführen (z.B. mittels Ankopplung einer unterbrechungsfreien Stromversorgung an die Einspeisungsschnittstelle). Das Medium kann beispielsweise ein temperiertes Fluid (auch als Temperierfluid bezeichnet, z.B. Kühlwasser), elektrische Energie, und/oder ein Kommunikationssignal (z.B. ein Netzwerksignal) sein. Jeder Versorgungspfad kann eingerichtet sein, mit der Rechenanlage in funktioneller Wechselwirkung zu stehen und das jeweils zugeführte Medium an die Rechenanlage weiterzugeben. Die Menge an Ver- und Entsorgungspfaden innerhalb des Containers kann hierin auch als Infrastruktur bezeichnet sein. Je nach Typ des Mediums (Temperierfluid, elektrische Energie, und/oder Kommunikationssignal) kann die Infrastruktur als Temperier-Infrastruktur, Energieversorgung-Infrastruktur (z.B. Stromversorgung-Infrastruktur) oder Telekommunikation-Infrastruktur bezeichnet sein. Beispielsweise kann die Temperier-Infrastruktur eingerichtet sein, der Rechenanlage entlang des Versorgungspfads thermische Energie zu entziehen. Optional können versorgungskritische Versorgungspfade oder Komponenten des Containers redundant vorhanden sein.

Die Redundanz bezeichnet das Vorhandensein funktional gleicher oder vergleichbarer Ressourcen eines technischen Systems, von denen bei einem störungsfreien Betrieb im Normalfall nicht alle benötigt werden. Eine funktionelle Redundanz kann aufweisen, dass zum Betrieb benötigte Versorgungspfade mehrfach parallel ausgelegt sind, damit beim Ausfall eines Versorgungspfades oder im Falle der Wartung ein anderer Versorgungspfad den Betrieb unterbrechungsfrei gewährleistet. Optional können die zueinander redundanten Versorgungspfade voneinander räumlich separiert sein, z.B. durch Schutzwände und/oder räumlichen Abstand (z.B. indem diese auf einander gegenüberliegenden Seiten des Containers angeordnet sind) um weitere Sicherheiten zu gewährleisten.

Als Redundanz eines Elements, das zum Betrieb der Rechenanlage verwendet wird (z.B. eines Versorgungspfads, einer Komponente dessen, oder eines Prozessors) kann hierin beispielsweise verstanden werden, dass zumindest eine funktional gleiche oder vergleichbare Kopie des Elements vorhanden ist, und das Element und dessen Kopie auch derart eingerichtet sind, dass zwischen diesen umgeschaltet werden kann, z.B. ohne dass der Betrieb der Rechenanlage unterbrochen werden muss. Das Element und dessen Kopie können dann anschaulich zueinander redundant (auch als zueinander redundantes Paar bezeichnet) eingerichtet sein.

Das Umschalten zwischen zwei zueinander redundanten Elementen (z.B. von einem ersten Versorgungspfad auf einen dazu redundanten Versorgungspfad) kann beispielsweise automatisiert erfolgen, wenn eine Fehlfunktion in dem aktiven Element erkannt wurde. Die Fehlfunktion kann beispielsweise als kritisch erkannt werden, d.h. dass diese zu einem Ausfall oder Teilausfall der Rechenanlage führen könnte. Das Umschalten kann beispielsweise mittels eines Transferschalters erfolgen, z.B. automatisiert. Die Vorzertifizierung kann beispielsweise erfordern, dass der Container eine zumindest teilweise redundante Infrastruktur aufweist. Alternativ oder zusätzlich, z.B. wenn ein Container als Teil eines Rechenzentrums selbst nur einen Teil der typischen Rechenzentrumskomponenten besitzt (z.B. können die Trafos, Generatoren und die Unterbrechungsfreie Stromversorgung (USV) zentralisiert und/oder außerhalb dessen angeordnet werden), können die redundanten Komponenten und Versorgungspfade zumindest einen Teil der Anforderungen für die Vorzertifizierung erfüllen (z.B. kann der Container zwei redundante Elektro-Unterverteilungen und zwei Versorgungswege aufweisen), so dass eine Vorzertifizierung prinzipiell die erwartete Verfügbarkeit bescheinigt, wenn außerhalb des Containers ebenfalls die Anforderungen erfüllt werden (z.B. Klassifiziert als "unterstützt Verfügbarkeitsklasse x", wobei x=1, 2, 3 oder 4 ist).

Gemäß verschiedenen Ausführungsformen kann die Redundanz als N+1-Redundanz ausgebildet sein. Eine N+1-Redundanz bezeichnet, dass die Rechenanlage maximal (z.B. genau) N Versorgungspfade zum Betrieb benötigt, wobei mindestens N+1 Versorgungspfade in dem Container vorhanden sind. Der N+1te Versorgungspfad kann als passiver Standby-Versorgungspfad eingerichtet sein. Fällt einer der N Versorgungspfade aus oder muss gewartet werden, so kann dessen Funktion von dem N+1ten Versorgungspfad übernommen werden, z.B. ohne dass der Betrieb der Rechenanlage unterbrochen werden muss. Fallen zwei der N Versorgungspfade aus, kann dies einen Ausfall oder Teilausfall der Rechenanlage zur Folge haben (entspricht beispielsweise Verfügbarkeitsklasse "VK 3" nach DIN EN 50600 oder "Tier 3" nach nordamerikanischem Standard des Uptime-Instituts). Dem könnte entgegengewirkt werden, indem eine höhere Redundanz verwendet wird, z.B. indem die Redundanz als parallel-Redundanz ausgebildet ist. Bei der parallel-Redundanz sind mindestens 2·N Versorgungspfade vorhanden, z.B. 2·(N+1) Versorgungspfade (entspricht beispielsweise Verfügbarkeitsklasse "VK 4" nach DIN EN 50600 oder "Tier 4" nach nordamerikanischem Standard des Uptime-Instituts).

Einpfadige Versorgungswege ohne Dopplung von Komponenten können hingegen "VK 1" bzw. "Tier 1" entsprechen, wobei zusätzlich zu den Verfügbarkeitsklassen weitergehende bautechnische Anforderungen (z.B. Einbruchsschutz, Brandschutz, u.v.m.) in den Normen definiert sein können. Das Rechenzentrum-Modul kann beispielsweise gemäß "VK 3" bzw. "Tier 3" Standard errichtet sein. Ein "VK 4" bzw. "Tier 4" Standard kann aufwändiger in seiner Erfüllung sein, (z.B. geeignet für kritische Infrastrukturen sein, wie beispielsweise für Energieversorgungsunternehmen gefordert).

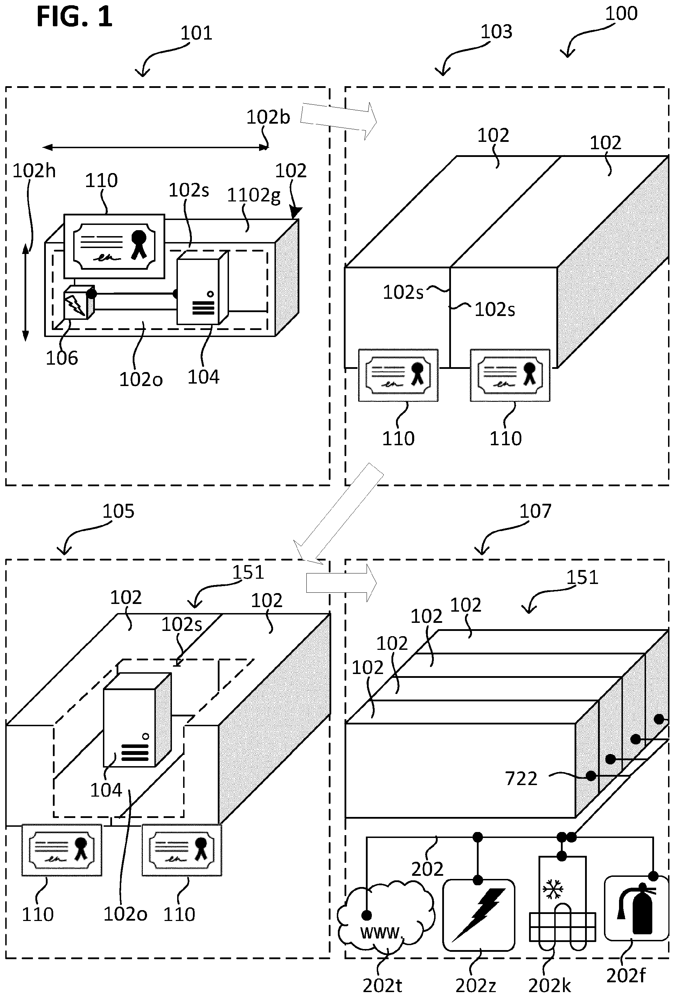

**Fig.1** veranschaulicht ein Verfahren 100 gemäß verschiedenen Ausführungsformen in einem schematischen Ablaufdiagramm zur Handhabung von mehreren Containern 102. Jeder Container 102 kann ein Gehäuse 1102g aufweisen, welches aneinandergrenzende (z.B. vier) Seitenwände, eine Decke und einen Boden aufweisen kann, die ein Inneres des Containers umgeben. Ferner kann das Gehäuse 1102g eine tragende Gehäusestruktur (z.B. ein Gestell oder Rahmen) aufweisen, an welcher die mehreren Seitenwände, die Decke und der Boden befestigt sind. Von den Seitenwänden des Containers 102 können mehrere Seitenwände 102s im Wesentlichen vollständig geöffnet werden (auch als Loswände 102s bezeichnet). Beispielsweise kann jede Loswand 102s zumindest ein (d.h. genau ein oder mehr als ein) Wandelement aufweisen, das geöffnet werden kann, z.B. indem dieses demontierbar, beweglich oder formschlüssig gelagert sein (z.B. mittels Scharnieren) kann. Der Rest der Loswand 102s, z.B. das Lager und/oder der Rahmen, kann beispielsweise stoffschlüssig (z.B. verschweißt) mit der Gehäusestruktur verbunden oder der Teil dieser sein. Das zumindest eine Wandelement jeder Loswand 102s kann beispielsweise eingerichtet sein, zerstörungsfrei geöffnet und/oder wieder verschlossen zu werden. Beispielsweise kann jede Loswand 102s mittels einer Verschlussvorrichtung (z.B. eine Verschlussfalle oder ein Schloss) verschlossen werden.

Als im Wesentlichen vollständig geöffnete Loswand 102s kann verstanden werden, als dass auf der Gehäuseseite des Containers 102, auf welcher die Loswand 102s angeordnet ist, im Wesentlichen vollständig das Innere des Containers freigelegt sein oder werden kann. Beispielsweise kann das Innere des Containers 102 eine Höhe 102h aufweisen, wobei eine mittels der geöffneten Loswand 102s bereitgestellte Öffnung 102o mindestens 80% (z.B. 90%) der Höhe 102h freilegt. Alternativ oder zusätzlich kann die Öffnung 102o mindestens 80% (z.B. 90%) einer Länge 102b bzw. Breite des Inneren (vgl. die innere Dimension) freilegen. Die Gehäusestruktur kann die Öffnung 102o optional segmentieren. Beispielsweise kann die Loswand 102s bezogen auf eine Fläche zu mindestens ungefähr 75% (z.B. 80%, 90% oder 95%) aus der Öffnung 102o bestehen, die mittels des zumindest einen Wandelements abgedeckt werden kann.

Der Container 102 kann im Inneren eine Rechenanlage 104 aufweisen, welche eine Vielzahl (z.B. mindestens 10, mindestens 100 oder mindestens 1000) Prozessoren aufweist. Der Container 102 kann ferner im Inneren eine Infrastruktur 106 zur Energieversorgung der Rechenanlage 104 (auch als Energieversorgung-Infrastruktur oder Strom-Infrastruktur bezeichnet) aufweisen. Die Energieversorgung-Infrastruktur 106 eines jeden Containers 102 kann hinsichtlich einer Ausfallsicherheit der Rechenanlage 104 einzeln vorzertifiziert 110 sein. Es können optional mehrere Infrastrukturen oder der ganze Container als Teil eines Rechenzentrums oder der Container mit zusätzlichen Technik-Containern vorzertifiziert sein. Der Container mit der vorzertifizieren Energieversorgung-Infrastruktur 106 wird im Folgenden auch als vorzertifizierter Container 102 (FOC oder vereinfacht als Container) bezeichnet.

Die Vorzertifizierung 110 kann anschaulich repräsentieren, wie groß die Ausfallsicherheit der Rechenanlage ist. Beispielsweise kann die Ausfallsicherheit (auch als Verfügbarkeit bezeichnet) mehr als 95% betragen, z.B. mindestens ungefähr 98,97%, z.B. mindestens ungefähr 99%, z.B. mindestens ungefähr 99,9% (auch als hohe Ausfallsicherheit bezeichnet), z.B. mindestens ungefähr 99,99% (auch als sehr hohe Ausfallsicherheit bezeichnet), z.B. mindestens ungefähr 99,999%. Die Ausfallsicherheit kann je nach Zertifizierungstyp klassifiziert sein oder werden, d.h. in Klassen (auch als Verfügbarkeitsklasse bezeichnet) eingeteilt sein.

Beispielsweise kann eine Vorzertifizierung gemäß DIN EN 50600 (von 2013, z.B. DIN EN 50600-1 von 2013, oder DIN EN 50600-2-2 von 2014 oder DIN EN 50600-2-3 von 2015) angeben, dass die Ausfallsicherheit von mindestens ungefähr 98,97% als Verfügbarkeitsklasse 1 klassifiziert ist, die Ausfallsicherheit von mindestens ungefähr 99,9% als Verfügbarkeitsklasse 2 klassifiziert ist, die Ausfallsicherheit von mindestens ungefähr 99,99% als Verfügbarkeitsklasse 3 klassifiziert ist, oder die Ausfallsicherheit von mindestens ungefähr 99,999% als Verfügbarkeitsklasse 4 klassifiziert ist.

Beispielsweise kann eine Vorzertifizierung gemäß amerikanischer Tier-Klassifikation (z.B. von 2015) angeben, dass die Ausfallsicherheit von mindestens ungefähr 99,671% als Verfügbarkeitsklasse 1 (auch als Tier 1 bezeichnet) klassifiziert ist, eine Ausfallsicherheit von mindestens ungefähr 99,749% als Verfügbarkeitsklasse 2 (auch als Tier 2 bezeichnet) klassifiziert ist, eine Ausfallsicherheit von mindestens ungefähr 99,982% als Verfügbarkeitsklasse 3 (auch als Tier 3 bezeichnet) klassifiziert ist, oder eine Ausfallsicherheit von mindestens ungefähr 99,995% als Verfügbarkeitsklasse 4 (auch als Tier 4 bezeichnet) klassifiziert ist.

Es können aber auch andere (z.B. gewerbliche) Zertifizierungstypen verwendet werden, z.B. eine Bitcom-Zertifizierung (z.B. gemäß Bitcom-Leitfaden 2013) oder eine InfraOpt-Zertifizierung (von 2017).

Je nach Zertifizierungstyp bzw. Verfügbarkeitsklasse können verschiedene Anforderungen an die Vorzertifizierung erfüllt sein, wie später genauer beschrieben wird, beispielsweise mindestens eine N+1-Redundanz (oder 2·N-Redundanz) der Energieversorgung-Infrastruktur 106. Die hierin beschriebene Vorzertifizierung 110 (hinsichtlich der Ausfallsicherheit) ist von anderen Zertifizierungstypen zu unterscheiden, insbesondere von solchen Zertifizierungstypen, welche die Erfüllung von Schutzvorgaben bescheinigen (z.B. CE/ETSI oder SEMKO). Solche Schutzvorgaben können sich beispielsweise auf den Schutz der Umwelt, den Schutz des Nutzers (z.B. dessen Unversehrtheit), den Schutz gegen Manipulation oder den Datenschutz beziehen und können beispielsweise gesetzlich vorgegeben sein.

Das Verfahren 100 kann in 101 aufweisen: Bereitstellen mehrerer FOC 102. Das Bereitstellen 101 kann optional in 103 aufweisen: Verlagern der mehreren FOC 102, z.B. zu Land, Wasser und/oder Luft. Das Verfahren 100 kann in 103 aufweisen: Anordnen der mehreren FOC 102 derart relativ beieinander, dass jeweils zwei FOC 102 der mehreren FOC 102 einander unmittelbar benachbart angeordnet sind. Beispielsweise können diese mit zumindest zwei (z.B. stirnseitigen oder längsseitigen) Loswänden 102s einander zugewandt angeordnet sein. Das Verfahren 100 kann in 105 aufweisen: Öffnen einer der mehreren Loswände 102s des oder jedes FOC 102, welche einem anderen FOC 102 der mehreren FOC 102 zugewandt ist. Der FOC 102 kann derart eingerichtet sein, dass beim Öffnen der Loswand 102s die Vorzertifizierung des FOC 102 (z.B. dessen Energieversorgung-Infrastruktur 106) erhalten bleibt. Dazu kann die oder jede Loswand 102s des FOC 102 beispielsweise frei von Elementen sein, welche die Vorzertifizierung beeinflussen, z.B. welche die Erfüllung der Anforderung gemäß der Vorzertifizierung beeinflussen. Damit kann anschaulich erreicht werden, dass nach dem Verbinden des Inneren der mehreren FOC 102 keine Zertifizierung des FOC 102 vorgenommen werden muss. Dies beschleunigt den Einsatz des Rechenzentrum-Moduls 151, welches die mehreren FOC 102 aufweist.

Der oder jeder FOC 102 kann optional eine Infrastruktur zur Temperierung (auch als Temperierung-Infrastruktur bezeichnet) und/oder zur Telekommunikation (auch als Telekommunikation-Infrastruktur bezeichnet) aufweisen. Optional können auch die Telekommunikation-Infrastruktur (z.B. eine Netzwerk-Infrastruktur) und/oder Temperierung-Infrastruktur jedes FOC 102 hinsichtlich der Ausfallsicherheit der Rechenanlage 104 einzeln vorzertifiziert 110 sein oder der ganze Container 102 kann samt seiner einen oder mehr als einen (z.B. verschiedenen) Infrastruktur vorzertifiziert 110 sein.

Die beieinander angeordneten FOC 102 können ein Rechenzentrum-Modul 151 bereitstellen. Mehrere Rechenzentrum-Module 151 können zu einem Rechenzentrum zusammengefügt werden, z.B. indem jeder FOC 102 mit einer externen Versorgungsmodulanordnung 202 gekoppelt wird.

Das Verfahren 100 kann in 107 aufweisen: Ankoppeln der mehreren FOC 102 untereinander und/oder mit zumindest einer externen Versorgungsmodulanordnung 202. Die oder jede Versorgungsmodulanordnung 202 kann ein oder mehr als ein zusätzliches Modul aufweisen, z.B. optional ein Telekommunikationsmodul 202t, ein Energiemodul 202z, ein Temperiermodul 202k (z.B. Kühlmodul) und/oder ein Gaslöschmodul 202f.

Beispielsweise können mehrere Versorgungsmodulanordnung 202 bereitgestellt sein, von denen jede Versorgungsmodulanordnung 202 genau einem FOC 102 oder genau einem Containerpaar unmittelbar gekoppelt ist. Optional können mehrere Versorgungsmodulanordnungen 202 mit demselben FOC 102 bzw. Containerpaar gekoppelt sein.

Das Ankoppeln kann beispielsweise aufweisen, die Telekommunikation-Infrastruktur der FOC 102 untereinander und/oder mit dem Telekommunikationsmodul 202t zu koppeln, die Temperierung-Infrastruktur der FOC 102 untereinander und/oder mit dem Temperiermodul 202k zu koppeln, und/oder die Energieversorgung-Infrastruktur 106 der FOC 102 untereinander und/oder mit dem Energiemodul 202z zu koppeln.

Im Folgenden kann zum einfacheren Verständnis allgemeiner auf eine Infrastruktur des FOC 102 Bezug genommen sein, wobei das für die Infrastruktur Beschriebene für die Energieversorgung-Infrastruktur 106, die Temperierung-Infrastruktur und/oder die Telekommunikation-Infrastruktur (z.B. in Analogie) gelten kann. Das Ankoppeln einer Infrastruktur kann im Allgemeineren mittels einer Ankoppel-Schnittstelle 722 erfolgen, an welcher die Infrastruktur entsprechende Anschlüsse aufweist. Beispielsweise kann die Infrastruktur eines FOC 102 an die Versorgungsmodulanordnung 202 mittels einer Einspeisungsschnittstelle (allgemeiner erste Ankoppel-Schnittstelle) oder an einen unmittelbar benachbarten FOC 102 mittels einer Container-zu-Container-Schnittstelle (allgemeiner zweite Ankoppel-Schnittstelle) angekoppelt werden.

Die Infrastruktur (z.B. die Telekommunikation-Infrastruktur, Energieversorgung-Infrastruktur und/oder Temperierung-Infrastruktur) kann beispielsweise mehrere erste Versorgungsleitungen aufweisen, welche die Einspeisungsschnittstelle mit der Rechenanlage oder einem Endgerät (z.B. einem Wärmetauscher) der Infrastruktur koppeln. Alternativ oder zusätzlich kann die Infrastruktur mehrere zweite Versorgungsleitungen aufweisen, welche die Container-zu-Container-Schnittstelle (CC-Schnittstelle) mit der Rechenanlage und/oder der Einspeisungsschnittstelle koppeln.

Beispielsweise weist die Telekommunikation-Infrastruktur eine Vielzahl von Netzwerkleitungen auf, welche die Ankoppel-Schnittstelle mit der Rechenanlage koppeln zum Verbinden der Vielzahl von Prozessoren mit einem lokalen und/oder globalen Netzwerk (z.B. dem Internet). Beispielsweise weist die Temperierung-Infrastruktur eine Vielzahl von Fluidleitungen (z.B. Rohre für Vor- und Rücklauf) auf, welche die Ankoppel-Schnittstelle(n) mit der Rechenanlage koppeln, so dass der Rechenanlage thermische Energie entzogen werden kann.

Die Versorgungsleitungen können beispielsweise in Trassen (z.B. hängende Kabeltrassen) an der Decke und/oder im Boden des FOC 102 angeordnet sein und einen Abstand von den Loswänden 102s aufweisen. Es kann beispielsweise ein Doppelboden zum Verlegen der Versorgungsleitungen verwendet werden. Die Ankoppel-Schnittstelle(n) 722 kann/können beispielsweise an Zwischenwänden befestigt sein und einen Abstand von den Loswänden 102s aufweisen. Damit kann erreicht werden, dass durch Öffnen der Loswände 102s die Vorzertifizierung nicht verloren geht. Um eine elektrische Leistung für den Betrieb der Rechenanlage 104 des FOC 102 bereitzustellen, kann jede (z.B. die erste und/oder die zweite) Ankoppel-Schnittstelle 722 eingerichtet sein, die elektrische Leistung oder ein Doppeltes davon bereitzustellen, z.B. eine Leistung von beispielsweise mehr als ungefähr 100 kW, als ungefähr 150 kW, als ungefähr 200 kW, als ungefähr 250 kW, oder als ungefähr 500 kW (Kilowatt).

In verschiedenen Ausführungsformen weist die Rechenanlage mehrere Recheneinheiten auf, von denen jede Recheneinheit mindestens eine Aufnahmevorrichtung (z.B. ein Rack aufweisend, wie beispielsweise ein 19-Zoll-Rack oder ein 21-Zoll-Rack) zum Aufnehmen von Prozessoren aufweist. Diese Aufnahmevorrichtung(en) kann/können beispielsweise Regale zum Aufnehmen von Prozessorkarten und/oder ganzen Servern sein (so genannte "Rigs"). Die oder jede Recheneinheit kann optional eine Kühlvorrichtung zum Kühlen der Prozessoren aufweisen (d.h. zum Entziehen von thermischer Energie), z.B. einen Passivkühler und/oder einen Wärmetauscher.

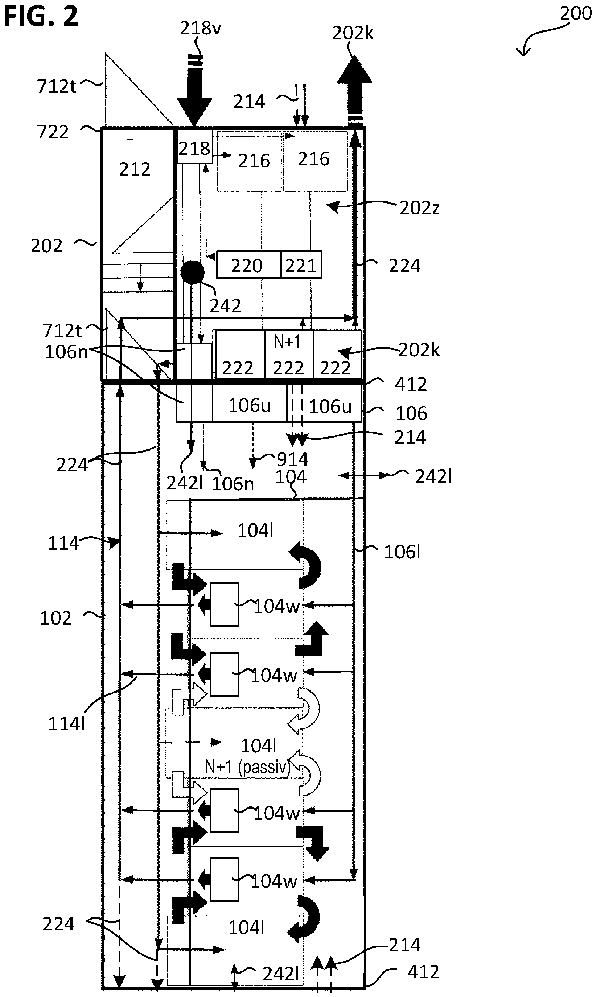

**Fig.2** veranschaulicht eine Versorgungskette 200 gemäß verschiedenen Ausführungsformen in einem schematischen Versorgungsdiagram, in welchem ein Energieflussdiagram mit verschiedenen Technik-Anbau-Containern dargestellt ist. Ein Rechenzentrum kann eine oder mehr als eine Versorgungskette 200 aufweisen, von denen jede Versorgungskette 200 eine Versorgungsmodulanordnung 202 (z.B. einen Versorgungscontainer und/oder Technikcontainer aufweisend, und optional einen Elektrocontainer und/oder Hydraulikcontainer aufweisend) und zumindest einen FOC 102 des Rechenzentrum-Moduls 151 aufweisen kann.

Die Versorgungsmodulanordnung 202 kann beispielsweise ein Schleusenmodul 212 (z.B. eine räumlich separierte Schleuse) aufweisen. Das Telekommunikationsmodul 202t kann beispielsweise zwei zueinander redundante Telekommunikationsanschlüsse 214 aufweisen. Dementsprechend kann die Telekommunikation-Infrastruktur (auch als TK-Infrastruktur bezeichnet) mindestens zwei redundante Telekommunikation-Versorgungspfade aufweisen, von denen jeder Telekommunikation-Versorgungspfad mit einem der Telekommunikationsanschlüsse 214 gekoppelt sein oder werden kann. Die TK-Infrastruktur oder ein TK-Pfad kann alternativ oder zusätzlich wegeredundant auf der gegenüberliegenden Containerseite an die TK-Anschlüsse 214 angeschlossen sein.

Das Energiemodul 202z kann beispielsweise eine Niederspannungshauptverteilung 218 und zwei damit gekoppelte und zueinander redundante unterbrechungsfreie Stromversorgungen 216 (USV) aufweisen, von denen jede USV 216 beispielsweise auf 250 kW (Kilowatt) oder mehr ausgelegt sein kann. Die Niederspannungshauptverteilung 218 kann beispielsweise mit einem regionalen Verbundnetz 218v gekoppelt sein. Das Energiemodul 202z kann beispielsweise einen oder mehr als einen Stromgenerator 220, z.B. Notromgenerator, aufweisen. Der Stromgenerator 220 kann beispielsweise einen Verbrennungsmotor (z.B. Dieselmotor) aufweisen. Der Stromgenerator kann beispielsweise von einem Dieseltank 221 für 72 oder 96 Stunden versorgt werden. Dementsprechend kann die Energieversorgung-Infrastruktur 106 mindestens zwei zueinander redundante Energie-Versorgungspfade aufweisen, von denen jeder Energie-Versorgungspfad mit einer der USV 216 gekoppelt sein oder werden kann. Jeder Energie-Versorgungspfad kann beispielsweise eine oder mehr als eine Unterverteilungsvorrichtung 106u (auch als UV bezeichnet) aufweisen, von denen jede UV 106u mit einer der mehreren USV 216 gekoppelt sein oder werden kann. Damit kann eine redundant zugeführte elektrische Energie bereitgestellt werden, wobei jeder Versorgungspfad den Ausfall eines anderen Versorgungspfads kompensieren kann. Beispielsweise kann eine erste UV 106u eine erste Energieleitung 106l und eine zweite UV 106u eine zweite Energieleitung 914 aufweisen, wobei die erste und die zweite Energieleitung eingerichtet sind, denselben Prozessor mit Energie zu versorgen. Optional kann die Energieversorgung-Infrastruktur eine von der Rechenanlage 104 separierte Grundstromverteilung 106n aufweisen, welche beispielsweise nicht der Rechenanlage 104 zugehörige Bestandteile des FOC 102 mit Energie versorgt (z.B. Licht, Lüftung, Kühlung), d.h. anschaulich eine Grundstromversorgung bereitstellt.

Das Temperiermodul 202k (hier beispielhaft zusammen mit dem Energiemodul 202z in einem Technikcontainer angeordnet) der Versorgungsmodulanordnung 202 kann eingerichtet sein, dem Inneren des FOC 102 (z.B. der Rechenanlage 104) thermische Energie zu entziehen, beispielsweise mittels eines Kühlfluids (z.B. einer Flüssigkeit). Beispielsweise kann das Temperiermodul 202k eine oder mehrere Wärmepumpe(n) 222 aufweisen, welche z.B. redundant zueinander eingerichtet sein können. Beispielsweise kann das Temperiermodul 202k einen oder mehr als einen Kühlkreislauf 224 (z.B. mit unterschiedlichen Temperaturniveaus Kühlwasser/Heißwasser und jeweils Vor- und Rücklaufleitungen) mit dem FOC 102 bereitstellen. Dazu kann die Temperierung-Infrastruktur 114 des FOC 102 eine oder mehr als eine Fluidleitung 114l aufweisen, welche mit einem oder mehr als einem Prozessorkühler 104w der Rechenanlage 104 gekoppelt ist. Der oder jeder Prozessorkühler 104w kann eingerichtet sein, den Prozessoren der Rechenanlage 104 thermische Energie zu entziehen und diese dem Kühlkreislauf 224 zuzuführen. Das so entstehende Warmwasser kann aus dem FOC 102 herausgebracht werden und/oder mittels der Wärmepumpen 222 abgekühlt werden.

Die Temperierung-Infrastruktur des FOC 102 kann beispielsweise eine oder mehr als eine Luftklimatisierung 104l (z.B. ein Umluftkühlvorrichtung) aufweisen, welche mit einer Kühlfluidzuführung des Kühlkreislaufs 224 gekoppelt ist. Die oder jede Luftklimatisierung 104l kann eingerichtet sein, der Luft innerhalb des FOC 102 thermische Energie zu entziehen (d.h. diese zu kühlen) und/oder der Rechenanlage gekühlte Luft zuzuführen. Zumindest zwei Fluidleitungen 114l und/oder Luftklimatisierungen 104l können optional redundant zueinander eingerichtet sein. Der Kühlkreislauf 224 kann beispielsweise mittels eines Kühlturmes, mittels eines Gewässers (z.B. Flusswasser und/oder Seewasser), mittels Nahkälte, mittels Fernkälte, mittels einer Kältemaschine und/oder mittels einer Wärmepumpe 222 gekühlt und/oder versorgt werden.

Die Versorgungsmodulanordnung 202 kann optional ein Havariemodul 242 aufweisen, welches beispielsweise eine oder mehr als eine Feuerlöschvorrichtung 242l des FOC 102 (z.B. eine Löschgaszuführung aufweisend) versorgen kann. Zumindest zwei Feuerlöschvorrichtung 242l (allgemeiner Feuerlösch-Infrastruktur 242l) des FOC 102 können optional redundant zueinander sein. Über eine Feuerlöschvorrichtung 242l können (beispielsweise genau) ein oder zwei FOC 102 versorgt werden, die mittels der Leitungen 242l miteinander verbunden werden können. Notwendige Überdrucköffnungen können stirnseitig neben den Türen der Schleuse 212 deckennah über der Normalstromverteilung 106 angeordnet sein und optional mittels eines Kanals über der Mittelspannungsverteilung 218 ins Freie verlängert sein.

Jeder Versorgungspfad einer oder mehr als einer Infrastruktur, wie beispielsweise der Strom-Infrastruktur 106, der Temperierung-Infrastruktur 114, der Telekommunikation-Infrastruktur 214 und/oder der Feuerlösch-Infrastruktur 242l kann an der Einspeisungsschnittstelle 412 zumindest ein entsprechendes Paar zueinander redundante Anschlüsse und/oder ein Paar aus Vor- und Rücklaufleitungen aufweisen.

Die Einspeiseschnittstellen 412, 722, können als standardisierte Verbindungen z.B. als Flanschverbindung, handelsübliche Steckverbindung oder anderweitig ausgebildet sein.

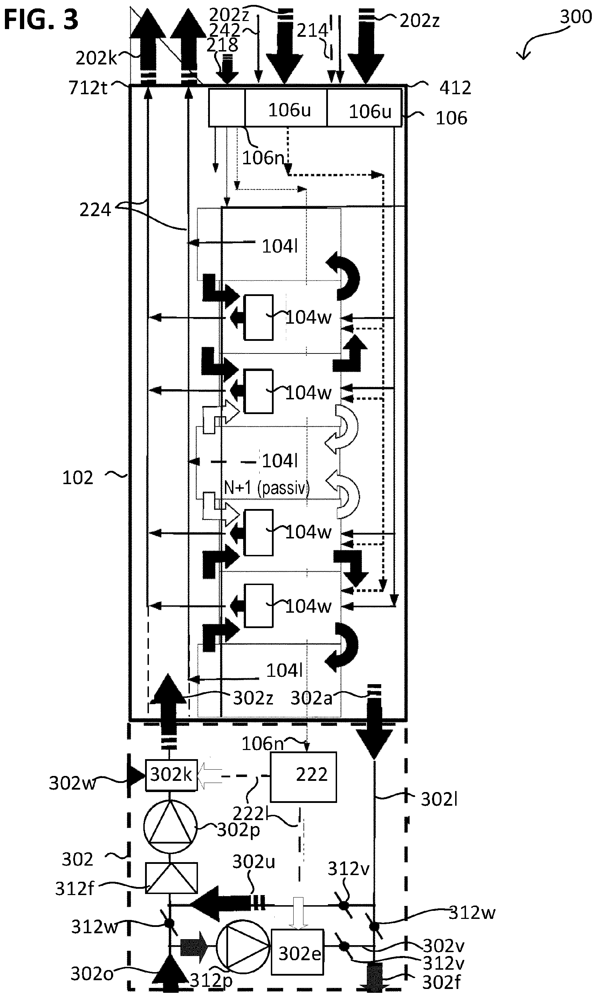

**Fig.3** veranschaulicht eine Versorgungskette 300 gemäß verschiedenen Ausführungsformen in einem schematischen Versorgungsdiagram, in welchem ein Energieflussdiagram mit verschiedenen Technik-Anbau-Containern dargestellt ist, z.B. die Versorgungskette 200.

Die Versorgungsmodulanordnung 202 der Versorgungskette 300 kann ein Lüftungsmodul 302 aufweisen. Der FOC 102 kann eine Luftansaugöffnung 302a (z.B. warme Abluft) und eine Luftabgabeöffnung 302z (z.B. kalte Zuluft) aufweisen, die mit dem Lüftungsmodul 302 gekoppelt sein oder werden können. Das Lüftungsmodul 302 kann ferner eine Luftkanalsystem 302l bereitstellen, welches die Luftansaugöffnung 302a und die Luftabgabeöffnung 302z sowie die Außenluftöffnung 302o und der Fortluftöffnung 302f miteinander verbindet.

Das Luftkanalsystem 302l kann einen Umluftbypass 302u und einen Entwärmungsbypass 302v enthalten. Mittels offener Luftklappen 312v und geschlossener Klappen 312w kann im Umluftbetrieb über den Umluftbypass 302u gefahren werden. Mittels geschlossener Luftklappen 312v und offener Klappen 312w kann im Außenluftbetrieb (auch als freie Kühlung bezeichnet) gefahren werden. Mit teilweise geöffneten Luftklappen 312v und 312w kann im Außenluftbetrieb die Zuluft 302z (freie Kühlung) auf ein Mindesttemperaturniveau erhöht werden mittels eines Teilvolumenstromes über den Umluftbypass 302u (Zulufttemperaturregelung).

Das Luftkanalsystem 302l kann mindestens einen Ventilator 302p aufweisen, welcher eingerichtet ist, dem FOC 102 Luft mittels der Luftansaugöffnung 302a (warme Abluft) zu entziehen, die Luft über einen Wärmetauscher 302k zu leiten (z.B. mittels diesem zu kühlen) und mittels der Luftabgabeöffnung 302z (z.B. kalte Zuluft) zuzuführen (auch als Umluftbetrieb bezeichnet). Der Ventilator 302p kann ebenfalls eine Funktion übernehmen, über die Außenluftöffnung 302o kalte Luft über die Zuluftöffnung 302z zu transportieren (auch als freie Kühlung bezeichnet). Der Ventilator 302k kann ebenfalls die Funktion einnehmen, den FOC 102 in einem Überdruck zu halten um Staub- oder Raucheintrag zu verhindern oder zu minimieren, z.B. beim Öffnen von Türen.

Es kann ein Luftfilter 312f möglichst nahe der Außenluftöffnung 302o angeordnet sein, der die Außenluft oder zusätzlich die Umluft filtert und den FOC 102, das Kanalsystem 302l und dessen Komponenten 302p, 302k und optional die Komponenten 312p, 202e weitestgehend staubfrei hält.

Das Lüftungsmodul 302 kann ferner eine Wärmepumpe 222 mit seinen Fluidleitungen 222l und einen oder mehrere Wärmetauscher 302k für die zu kühlende Seite und 302e für die Wärmeabgabe aufweisen. Die Wärmepumpe(n) oder Kältemaschine(n) werden beispielsweise mit Normalstrom 106n versorgt.

Alternativ kann der Wärmetauscher 302k auch mittels eines Gewässers (z.B. Fluss-/Seewasser), mittels Nahkälte, mittels Fernkälte, mittels einer Kältemaschine 302w und/oder mittels des Entwärmung-Rohrsystem 224 gekühlt werden.

Das Lüftungsmodul 302 kann ferner eine Wärmeabgabeanordnung 302v aufweisen, welche eingerichtet ist, die thermische Energie nach außen abzugeben und um Anbauten außerhalb des Containers 302 zu vermeiden. Die Wärmeabgabeanordnung 302v kann einen Wärmetauscher 302e aufweisen, der mit der Wärmepumpe 222 über das Rohrsystem 222l gekoppelt ist. Die Wärmeabgabeanordnung 302v kann ferner einen zusätzlichen Ventilator 312p aufweisen, welcher eingerichtet ist, kältere Außenluft 302o durch den Entwärmungsbypass 302v und über den Wärmetauscher 302e zu führen und über ein Fortluftgitter 302f erwärmt an die Außenluft abzugeben. Der Luftstrom wird in diesem Fall durch die geöffneten Luftklappen 312v geleitet und durch die geschlossenen Klappen 312w blockiert.

Das Lüftungsmodul 302 hat beispielsweise eine Luftleistung im Bereich von 1000 bis 11000 m³/h (Kubikmeter pro Stunde) bei einer Pressung von 50 bis 200 Pa (Pascal), beispielsweise eine Luftleistung im Bereich von 9000 bis 11000 m³/h bei einer Pressung von 75 bis 175 Pa, oder beispielsweise eine Luftleistung im Bereich von 9800 bis 10200 m³/h bei einer Pressung von 100 bis 150 Pa.

Der Wärmetauscher 202k kann beispielsweise eine Leistung von 90 kW oder mehr, die Wärmepumpe beispielsweise eine Nennwärmeleistung von 120 kW oder mehr aufweisen.

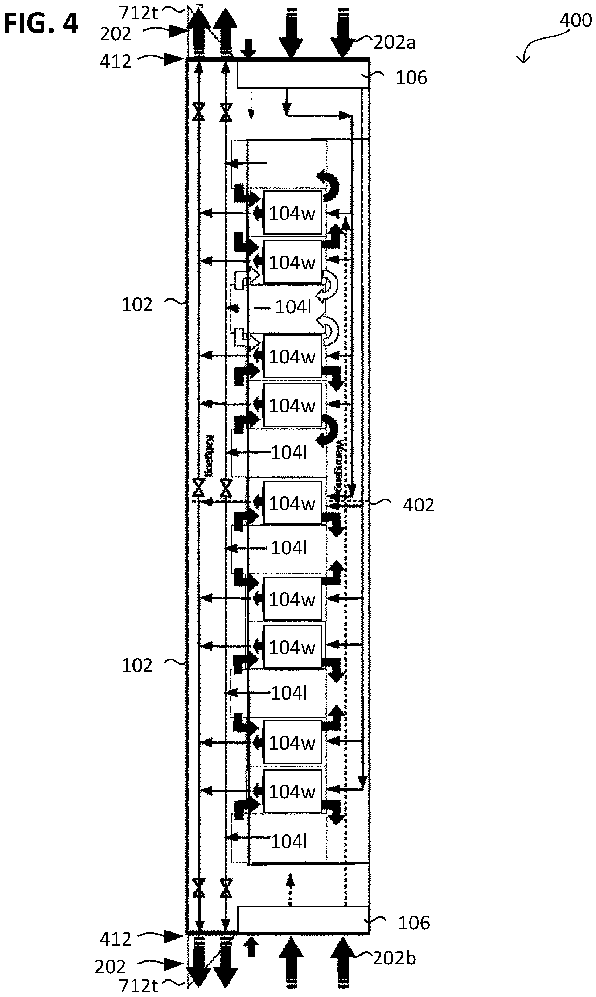

**Fig.4** veranschaulicht ein Rechenzentrum-Modul 151 gemäß verschiedenen Ausführungsformen in einem schematischen Versorgungsdiagram 400. Das Rechenzentrum-Modul 151 kann zwei FOC 102 (auch als Containerpaar bezeichnet) aufweisen, welche mittels ihrer CC-Schnittstellen 402 miteinander gekoppelt sind. Das Rechenzentrum-Modul 151 (z.B. jeder FOC 102 dessen) kann optional mittels seiner Einspeisungsschnittstelle(n) 412 mit einer Versorgungsmodulanordnung 202 gekoppelt sein, z.B. gemäß der Versorgungskette 200 oder 300.

Jeder FOC 102 des Containerpaars kann der CC-Schnittstelle 402 gegenüberliegend die Einspeisungsschnittstelle 412 aufweisen, welche optional mit der dem FOC 102 zugeordneten Versorgungsmodulanordnung 202 gekoppelt ist oder mit einer oder mehr als einer der zentralen Versorgungsanlagen 202z, 202k, 202f gekoppelt ist. Die CC-Schnittstelle 402 kann eingerichtet sein, die Versorgungsleitungen der Infrastruktur (z.B. der Energieversorgung-Infrastruktur, der Telekommunikation-Infrastruktur und/oder der Temperierung- bzw. Gaslösch-Infrastruktur) der zwei FOC 102 miteinander zu koppeln. Die Infrastrukturen der zwei FOC 102 können dazu beispielsweise spiegelsymmetrisch zueinander eingerichtet sein, z.B. deren CC-Schnittstelle 402 und/oder Versorgungsleitungen.

Die CC-Schnittstelle 402 ermöglicht es, die für einen FOC 102 zueinander redundanten Bestandteile der Versorgungsmodulanordnung 202 für zwei FOC 102 zu nutzen. Beispielsweise kann ein oder mehr als ein erster Anschluss 202a der Einspeisungsschnittstelle 412 (auch als erster Einspeisungsanschluss 202a bezeichnet) des ersten FOC 102 mittels dessen CC-Schnittstelle 402 mit einem zweiten FOC 102 gekoppelt sein oder werden. Alternativ oder zusätzlich kann ein oder mehr als ein zweiter Einspeisungsanschluss 202b des zweiten FOC 102 mittels dessen CC-Schnittstelle 402 mit dem ersten FOC 102 gekoppelt sein oder werden. Mehrere erste Einspeisungsanschlüsse 202a und/oder mehrere zweite Einspeisungsanschlüsse können redundant zueinander und/oder auf einander gegenüberliegenden Seiten der Einspeisungsschnittstelle 412 angeordnet sein. Jede erste und/oder zweite Einspeisungsanschluss 202b können beispielsweise zum Versorgen mit Energie, Telekommunikation und/oder Löschgas eingerichtet sein.

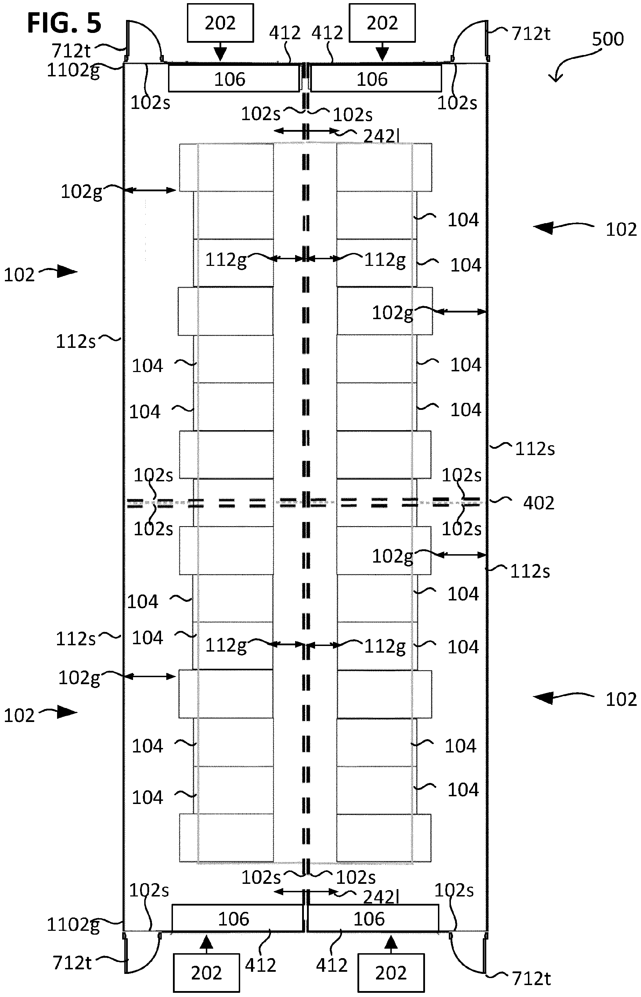

**Fig.5** veranschaulicht ein Rechenzentrum-Modul 151 gemäß verschiedenen Ausführungsformen in einem schematischen Versorgungsdiagram 500. Das Rechenzentrum-Modul 151, dessen FOC 102, kann mit mehreren Versorgungsmodulanordnungen 202 gekoppelt sein, z.B. gemäß der Versorgungskette 200 oder 300.

Jeder FOC 102 kann drei aneinandergrenzende Loswände 102s aufweisen. Zum Bilden des Rechenzentrum-Moduls 151 können die Loswände 102s jedes FOC 102 geöffnet werden (z.B. demontiert werden) und die aneinandergrenzenden FOC 102 mittels einer Dehnungsfuge physisch miteinander verbunden werden. Mit anderen Worten kann eine Loswand 102s ein demontierbares oder schwenkbare gelagertes Wandelement (anschaulich eine große Tür) aufweisen. Die Loswände 102s können aber auch anders eingerichtet sein. Beispielsweise kann eine Loswand 102s eine Falttür aufweisen (auch als Faltwand bezeichnet).

Somit können eine erste Loswand 102s und eine zweite Loswand 102s jedes FOC 102, die einem anderen FOC 102 zugewandt ist, geöffnet sein oder werden. Die erste Loswand 102s kann geöffnet die stirnseitige CC-Schnittstelle 402 freilegen. Eine dritte Loswand 102s kann geöffnet die stirnseitige Einspeisungsschnittstelle 412 freilegen. Optional kann die Einspeiseschnittstelle 412 und die CC-Schnittstelle 402 gleich bzw. gespiegelt angeordnet und ausgeführt (z.B. gleiche Durchmesser und Abstände) sein.

Die vierte Seitenwand 112s (auch als Festwand 112s bezeichnet) kann beispielsweise monolithisch eingerichtet und/oder stoffschlüssig mit der Gehäusestruktur des FOC 102 verbunden bzw. Teil dieser sein.

Entlang der Längserstreckung jedes FOC 102 (d.h. auf dessen Längsseiten) kann dieser zwei Gänge 102g, 112g aufweisen, zwischen denen die Rechenanlage 104 angeordnet ist und von denen jeder Gang zwischen der Rechenanlage 104 und einer Seitenwand des FOC 102 (z.B. diese räumlich voneinander separiert) angeordnet ist. Ein an die zweite Loswand 102s angrenzender erster Gang 112g kann schmaler ausgebildet sein als ein an die Festwand 112s angrenzender zweiter Gang 112g. Mit anderen Worten kann die Rechenanlage 104 näher an der zweiten Loswand 102s als an der Festwand 112s angeordnet sein.

Dies ermöglicht es, eine breitere Rechenanlage 104 zu verbauen, ohne dass die Gangbreite zu schmal wird. Anschaulich können die zweiten Gänge 112g der FOC 102 aneinandergrenzen und so mittels der geöffneten zweiten Loswand 102s miteinander (zu einem Mittelgang 112g, 112g) verbunden sein oder werden, so dass eine ausreichende Gangbreite bereitgestellt wird. Beispielsweise kann die Breite des Mittelgangs eine Anforderung der Vorzertifizierung erfüllen oder dem Kundenwunsch nach ausreichend Wartungsraum entgegenkommen. Alternativ oder zusätzlich kann die Gangbreite jedes zweiten Gangs 112g kleiner sein als 0,7 m (Meter) und/oder größer als 0,3 m. Alternativ oder zusätzlich kann die Gangbreite jedes ersten Gangs 102g größer sein als 0,7 m.

Mit der Gaslösch-Schnittstelle 242l kann der Raumverbund aus zwei nebeneinander aufgestellten FOC 102 von (z.B. genau) einer Gaslöschzentrale 202f bzw. einem Gasflaschensystem 242 bzw. einer Steuerung effizient und normgerecht versorgt werden.

Mehr als zwei FOC 102 können wie in Versorgungsdiagram 500 dargestellt horizontal nebeneinander angeordnet sein. Alternativ oder zusätzlich können mehr als zwei FOC 102 übereinander angeordnet sein (z.B. gestapelt werden).

Das Paar mittels der CC-Schnittstelle 402 miteinander gekoppelter FOC 102 kann als Containerpaar ersten Typs bezeichnet sein. Zwei Containerpaare ersten Typs können jeweils den Mittelgang 112g, 112g bilden. Alternativ oder zusätzlich zu einem Containerpaar ersten Typs kann ein FOC 102 verwendet werden, der zwei zueinander spiegelsymmetrisch aufgebaute Rechenanlagen und Infrastrukturen aufweist (so dass die CC-Schnittstelle 402 weggelassen ist).

Mit anderen Worten, ein FOC 102 kann einzeln stehen und/oder an der/den kurzen Stirnseite(n) mit einem Versorgungsmodul 202 (z.B. einen Technik-Container, einen Elektro-Container und/oder einen Hydraulik-Container aufweisend) sowie optional mit einem Lüftungs-Container 302 verbunden sein (vgl. Fig.2 und 3).

In einer zusätzlichen Aufstellkonfiguration können zwei FOC 102 (z.B. zwei 20ft-Container) mit der kurzen Stirnseite zu einem Verbund (z.B. einer 40ft Variante) kombiniert sein (auch als Längsverbund bezeichnet). Alternativ oder zusätzlich zu dem Längsverbund aus zwei FOC 102 kann ein größerer (z.B. ein 40ft-Container) verwendet werden, was es ermöglicht, dass die Schnittstelle 402 (Fig.4) zwischen den zwei FOC 102 nicht nötig ist.

Zwei FOC 102 können aber auch über die lange Loswand 102s miteinander kombiniert werden (auch als Breitverbund bezeichnet), um einen breiteren hinteren bzw. mittleren Wartungsgang zu schaffen, ohne über die Schnittstelle 402 einen Längsverbund (z.B. einen 40ft-Verbund) herstellen zu müssen (vgl. Fig.5, jeweils oberer Breitverbund oder unterer Breitverbund des Rechenzentrum-Moduls 151). Es kann aber auch ein großer Breitverbund (allgemeiner Raumverbund) mittels vier FOC 102 hergestellt werden (Fig.5), von denen beispielsweise jeweils zwei FOC 102 als Längsverbund bereitgestellt sind.

Alternativ oder zusätzlich kann eine vertikale Kombination/Erweiterung erfolgen, bis beispielsweise maximal 6 FOC 102 übereinander angeordnet sind.

Basis aller Aufstellkonfigurationen kann die gleiche bzw. symmetrisch aufgebaute Plattform des FOC 102 sein, die lediglich spiegelsymmetrisch bezüglich der Außenwände 102s des FOC 102 ausgeführt sein kann.

Ein FOC 102 als IT-Container kann einzeln oder im Verbund optional mit einem oder mehreren Technik-Container und/oder einem oder mehreren Elektro-Containern, Hydraulik-Containern oder Feuerlösch-Containern und anderen Infrastruktur-Komponenten wie z.B. Generatoren direkt oder indirekt zu einem Rechenzentrum verbunden sein.

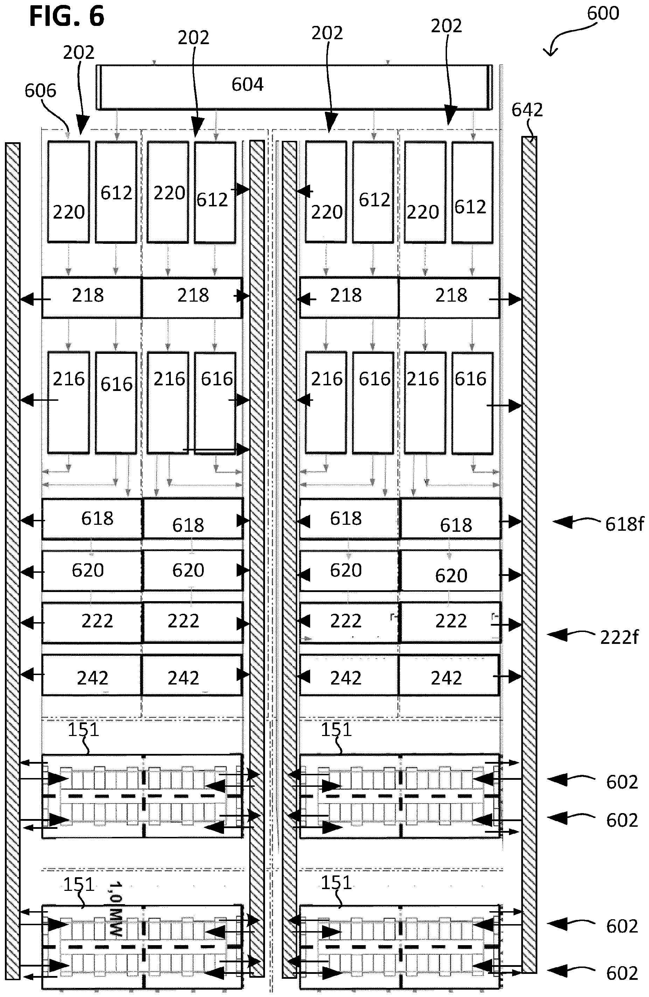

**Fig.6** veranschaulicht ein Rechenzentrum 600 gemäß verschiedenen Ausführungsformen in einem schematischen Versorgungsdiagram. Mehrere Rechenzentrum-Module 151 des Rechenzentrums 600 können wie in Versorgungsdiagram dargestellt horizontal nebeneinander angeordnet sein. Alternativ oder zusätzlich können mehrere Rechenzentrum-Module 151 des Rechenzentrums 600 übereinander angeordnet sein (z.B. gestapelt werden).

Ein jedes Containerpaar 602 jedes Rechenzentrum-Moduls 151 kann mit zwei Versorgungsmodulanordnungen 202 gekoppelt sein, z.B. gemäß der Versorgungskette 200 oder 300. Die zwei Versorgungsmodulanordnungen 202 können redundant zueinander sein und/oder ein jedes mit zwei Containerpaaren 602 gekoppelt sein (z.B. mittels separater Versorgungstrassen 642).

Das Rechenzentrum kann eine Mittelspannungshauptverteilung 604 aufweisen, welche mit jeder Versorgungsmodulanordnung 202 gekoppelt ist. Jede Versorgungsmodulanordnung 202 kann optional mit einer Treibstoffzuführung 606 (z.B. Gas oder Diesel zuführend) gekoppelt sein. Jede Versorgungsmodulanordnung 202 kann mehrere modular bereitgestellte Versorgungsvorrichtungen (dann auch als Module bezeichnet) aufweisen, z.B. einen Transformator 612, einen Stromgenerator 220, eine Niederspannungshauptverteilung 218, eine USV 216, eine Normalstromverteilung 616, eine Kaltwasserzuführung 618 (z.B. Kaltwassererzeugung 618), einen Kühlturm 620, eine Wärmepumpenanlage 222 und/oder ein Havariemodul 242 (z.B. eine Löschgasreservoir aufweisend).

In verschiedenen Ausführungsformen sind die Wärmepumpen 222 der Versorgungsmodulanordnung 202 Hochtemperatur-Wärmepumpen. Je nach Wärmepumpe kann dann von einem Temperaturniveau von beispielsweise mindestens 30°C, beispielsweise mindestens 40°C, beispielsweise mindestens 50°C, beispielsweise mindestens 60°C dem FOC 102 Wärme entzogen werden und diese Wärme auf ein höheres Temperaturniveau von beispielsweise mindestens 50°C, beispielsweise mindestens 60°C, beispielsweise mindestens 70°C oder 85°C angehoben werden.

Alternativ oder zusätzlich zu der Kaltwassererzeugung 618 kann ein Fernkälteanschluss 618f vorhanden sein. Zusätzlich zur Wärmepumpenanlage 222 in Verbindung mit dem Kühlturm 620 kann eine Fern- oder Nahwärmeleitung 222f angeschlossen sein, um die Abwärme einer Nutzung zuzuführen.

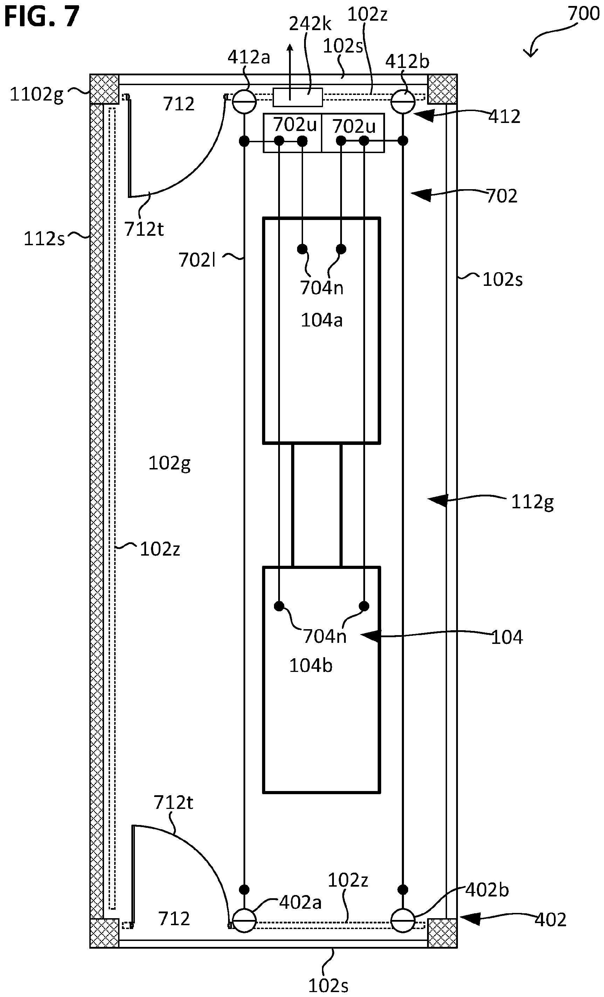

**Fig.7** veranschaulicht einen vorzertifizierten FOC 102 gemäß verschiedenen Ausführungsformen in einer schematischen Aufbaudiagram 700. Der FOC 102 kann in seiner Gehäusestruktur 1102g zumindest drei Loswände 102s aufweisen, optional eine Festwand 112s und eine oder mehr als eine Infrastruktur 702 (z.B. die Energieversorgung-Infrastruktur 106, die Temperierung-Infrastruktur und/oder die Telekommunikation-Infrastruktur). Die Festwand 112s kann beispielsweise entlang einer Längserstreckung des FOC 102 verlaufen und/oder auf einer Längsseite des FOC 102 angeordnet sein. Die Festwand 112s und die zweite Loswand 102s (auch als längsseitige Seitenwände bezeichnet) können einander gegenüberliegend angeordnet sein. Ferner können die erste Loswand 102s und die dritte Loswand 102s (auch als stirnseitige Loswände bezeichnet) einander gegenüberliegend angeordnet sein.

Zwischen der Rechenanlage 104 und der ersten Loswand 102s und der dritten Loswand 102s kann jeweils eine (z.B. zwischen an der Gehäusestruktur befestigte) Zwischenwand 102z angeordnet sein. Zwischen den zwei Zwischenwänden 102z können die Rechenanlage 104 und/oder die Versorgungsleitungen 702l der Infrastruktur 702 angeordnet sein. Jede Zwischenwand 102z kann optional eine Türöffnung 712 aufweisen, in der beispielsweise eine Tür 712t (auch als Personentür 712t bezeichnet) angeordnet sein kann. Die Türöffnung 712 kann beispielsweise eine Breite von weniger als der Hälfte der inneren Dimension des FOC 102 und/oder als ungefähr 1,5 m, z.B. als ungefähr 1 m, aufweisen. Die Personentür 712t kann eine Sicherheitstür sein. Die Sicherheitstür 712t kann abschließbar und/oder feuerfest und/oder rauchdicht eingerichtet sein. Beispielsweise kann die Sicherheitstür 712t eine Zutrittskontrolle ermöglichen.

Ferner kann die Infrastruktur 702 mindestens ein Paar (z.B. zwei Paare) zueinander redundante Versorgungspfade 702u aufweisen, von denen jedes Paar die Einspeisungsschnittstelle 412 mit der Rechenanlage 104 koppelt. Beispielsweise kann jede Recheneinheit 104a, 104b der Rechenanlage 104 mit einem Paar zueinander redundante Versorgungspfade 702u gekoppelt sein. Dazu kann die Recheneinheit 104a, 104b beispielsweise eingerichtet sein, zwischen einem Paar zueinander redundanter Infrastruktur-Ankopplungen 704n (z.B. pro Recheneinheit 104a, 104b) der Rechenanlage 104 umzuschalten. Alternativ oder zusätzlich kann die Infrastruktur 702 eingerichtet sein, zwischen den zueinander redundanten Versorgungspfaden 702 eines Paars umzuschalten. Das Umschalten kann beispielsweise mittels eines automatischen Transferschalters erfolgen. Die Infrastruktur-Ankopplung kann eingerichtet sein, die Infrastruktur an die Rechenanlage 104 anzukoppeln. Die Infrastruktur-Ankopplung kann beispielsweise ein Netzteil oder eine Telekommunikationsvorrichtung der Rechenanlage 104 sein.

Beispielsweise kann die Einspeisungsschnittstelle 412 zumindest ein Paar zueinander redundante Einspeisungsanschlüsse 412a, 412b aufweisen, von denen ein erster Einspeisungsanschluss 412a mittels zumindest einer ersten Versorgungsleitung 702l mit der Rechenanlage 104 (z.B. jeder Recheneinheit 104a, 104b) gekoppelt ist, und von denen ein zweiter Einspeisungsanschluss 412b mittels zumindest einer zweiten Versorgungsleitung 702l mit der Rechenanlage 104 (z.B. jeder Recheneinheit 104a, 104b) gekoppelt ist. Jeder der Versorgungspfade kann beispielsweise mehrere Versorgungsleitungen aufweisen und/oder eine Verteilereinheit, welche die mehreren Versorgungsleitungen mit der Einspeisungsschnittstelle 412 koppelt.

Optional kann die Infrastruktur 702 die Einspeisungsschnittstelle 412 mit der CC-Schnittstelle 402 koppeln. Beispielsweise kann die CC-Schnittstelle 402 zueinander redundante CC-Anschlüsse 402a, 402b aufweisen, von denen zumindest ein erster CC-Anschluss 402a mit dem zumindest einen ersten Einspeisungsanschluss 412a gekoppelt ist, und zumindest ein zweiter CC-Anschluss 402b mit dem zumindest einen zweiten Einspeisungsanschluss 412b gekoppelt ist. Die CC-Schnittstelle 402 und/oder die Einspeisungsschnittstelle 412 können jede an verschiedenen Zwischenwänden 102z angebracht sein.

Optional kann eine zusätzliche Zwischenwand 102z an der Festwand 112s angeordnet sein, und ein oder mehr als ein Bestandteil des FOC 102, z.B. der Infrastruktur 702, einer Benutzerschnittstelle oder Ähnlichem tragen. Die zusätzliche Zwischenwand 102z ermöglicht es, die Festwand 112s unverändert zu lassen und/oder den FOC 102 zusätzlich wärmezudämmen.

Der vorzertifizierte FOC 102 kann beispielsweise auf den etablierten Containervertriebswegen LKW, Binnenschiffe, Hochsee-Container-Schiffe international transportiert werden. Der FOC kann nach außen hin unverändert sein, um das internationale CSC-Zertifikat oder ein anderes Transportzertifikat (z.B. für den internationalen Transport) zu behalten und/oder um möglichst unauffällig auszusehen. Beispielsweise können alle Containeraußenwände im Wesentlichen vollständig unbearbeitet (z.B. ohne Löcher bzw. Einbauten) sein, um die CSC-Zulassung für den internationalen Transport zu behalten. Dies wird beispielsweise mittels der Zwischenwände 102z ermöglicht.

Der FOC 102 (bzw. die Rechenanlage 104) kann beispielsweise hoch ausfallsicher eingerichtet sein, durch eine redundante Infrastruktur 702, die beispielsweise die Anforderungen einer europäischen und/oder internationalen Zertifizierung hinsichtlich der Ausfallsicherheit der Rechenanlage 104 erfüllt (z.B. mindestens gemäß der Verfügbarkeitsklasse 3). Anschaulich kann der FOC 102 eine höchstmögliche Leistungsdichte bei hoher Ausfallsicherheit und praktischem, rechenzentrumstypischen Innendesign ermöglichen. Weiterhin kann eine maximale Anwendbarkeit erreicht werden, z.B. indem der FOC 102 ein Standard-20ft-Container, ein Standard-40ft-Container (z.B. für Skalierungen) oder ein Standard-10ft-Container ist. Optional kann durch spiegelsymmetrische Ausgestaltung mehrerer FOC 102 eine Paarbildung und damit eine erhöhte Modularität erreicht werden. Alternativ oder zusätzlich kann die Medienzuführung (beispielsweise Energie, Temperierfluid, Frischluft, Kommunikation, usw.) von außen erfolgen mittels modularer Versorgungsvorrichtungen, z.B. mittels stirnseitig ansetzbarer Haustechnik-Container. Der FOC 102 kann optional einen Doppelboden für eine elektrostatische Ableitung und/oder zur Aufnahme der Versorgungsleitungen aufweisen.

Der FOC 102 kann als mehrseitig (z.B. dreiseitig) öffenbarer Container ausgebildet sein, welcher beispielsweise nur an einer Stirnseite eingespeist werden kann (z.B. eingebrachte Medien aufweist) und/oder nur an einer Stirnseite eine Personentür aufweist, so dass ein in 4 Richtungen (oben, links, rechts und in Richtung der anderen Stirnseite) skalierbares Rechenzentrum gebildet werden kann.

Die beidseitige Nutzung des zweiten Gangs 112g (als Wartungsgang) kompensiert die geringe Breite des FOC 102. Damit wird die Platzknappheit hinter den Recheneinheiten 104a, 104b kompensiert. Einen oder mehr als eine Loswand 102s kann bei Bedarf, z.B. einer Erweiterung mit zusätzlichen FOC 102, geöffnet, z.B. abgenommen, werden.

Der oder jeder FOC 102 des Rechenzentrum-Moduls 151 kann an einem Standort in Betrieb genommen werden, welcher (z.B. dessen Versorgungsmodulanordnung) ebenfalls den Anforderungen hinsichtlich der Ausfallsicherheit (z.B. Internetgeschwindigkeit, Erdbebensicherheit, Überflutungssicherheit, Stromverfügbarkeit, usw.) genügt. Der Standort kann beispielsweise aufweisen: zwei separate Stromzuleitungen, zwei Anschlüsse unterschiedlicher Internetserviceprovider (z.B. Glasfaser), ein optionales Wärmenetz zur Abführung rückgenutzter Abwärme, einen optionalen Fernkälteanschluss und/oder Tiefenwasseranschluss, einen optionalen Gasanschluss, einen optionalen Trink- und/oder Abwasseranschluss.

Ein oder mehr als ein Medium kann mittels der Versorgungsmodulanordnung 202 lokal bereitgestellt werden, z.B. Kaltwasser (ca. 18°C und/oder 24°C aufweisend und/oder mit einem Temperaturunterschied von 6 Kelvin oder mehr), eine Trockenkühlung (z.B. mittels Gas), eine Niederspannung 400 V (Wechselstrom - AC) erzeugt aus einer Mittelspannung (mittels eines Transformators 612), einen unterbrechungsfreien Strom (z.B. mittels USV), einen optionalen Generatorstrom (z.B. mittels eines Generators), ein optionales zentrales Löschgas, einen optionalen zentralen Wasser-zu-Wasser-Wärmetransport.

Die USV kann beispielsweise einen elektrischen Energiespeicher (z.B. Akkumulatoren oder andere Batterien) aufweisen, die eingerichtet sind, eine Leistung gemäß der Leistungsaufnahme der Rechenanlage für mehrere Minuten (z.B. ungefähr 15 Minuten oder mehr) bereitzustellen. Der Generator kann optional einen Vorratsbehälter aufweisen, der eingerichtet ist, Treibstoff (z.B. Gas oder Diesel) gemäß einem Verbrauch des Generators für mindestens 24 Stunden (z.B. 72 Stunden oder 96 Stunden oder mehr) aufzunehmen. Der Wasser-zu-Wasser-Wärmetransport kann mittels einer Wärmepumpe, z.B. einer Hochtemperatur-Wärmepumpenanlage, bereitgestellt sein oder werden.

Die Infrastruktur 702 kann eingerichtet sein, hinsichtlich der Ausfallsicherheit der Rechenanlage 104 die Anforderungen der Verfügbarkeitsklasse 2 oder höher (z.B. der Verfügbarkeitsklasse 3) zu erfüllen und dementsprechend vorzertifiziert sein, z.B. gemäß Tier und/oder gemäß DIN EN 50600.

Die Gehäusestruktur (z.B. Festwand) des FOC 102 kann aus Stahl sein, welche optional eine oder mehr als eine Personentür aufweisen kann. Das Gestell des FOC kann vier Eckstahlträger und deren horizontale Stahl-Verbindungsträger (und optional die Bodenkonstruktion) aufweisen, welche an die Zwischenwände 102z angrenzen. Die Gehäusestruktur kann eingerichtet sein, das Gewicht des FOC 102 oder mehr (z.B. mindestens das zwei oder dreifache dessen) zu tragen. Damit können mehrere FOC 102 übereinander gestapelt werden (z.B. bis zu 8 FOC 102). Optional kann der FOC frei von Fenstern (z.B. Verglasungen) sein. Jede Loswand 102s kann eine nicht-tragende Seitenwand sein, deren Entfernung die Tragfähigkeit des FOC 102 im Wesentlichen nicht beeinflusst.

Die stirnseitigen Zwischenwände 102z können beispielsweise einbruchssicher eingerichtet sein (z.B. aus Metall) und optional verschließbare und/oder einbruchssichere Türen 712t aufweisen, die mittels des ersten Gangs 102g miteinander verbunden sind. Die Einbruchssicherung der Zwischenwände 102z oder zumindest der Personentür(en) kann beispielsweise die Anforderungen einer Widerstandsklasse (RC) gemäß DIN EN 1627 (von 2011) erfüllen, z.B. der Widerstandsklasse 2 (RC2) oder mehr, z.B. der Widerstandsklasse 3 (RC3) oder mehr. Die stirnseitigen Zwischenwände 102z können als dichte und druckfeste Wände derart stabil (z.B. mit einem verringerten Ständerabstand) ausgeführt sein, dass eine Löschgasanlage 242 bzw. 202f im Auslösefall weniger oder keine (anschaulich unzulässigen) Durchbiegungen verursacht und/oder mit einer Überdruckklappe 242k (z.B. oben neben der Türöffnung 712 in den Abmessungen 250x250 mm oder kleiner) ausgestattet sein, die ein sicheres ableiten eines Löschgases ermöglicht.

Der optionale Doppelboden des FOC 102 kann als Techniksichtschutz, Erhöhung Türunterkante über Schneehöhe und/oder Überflutungsschutz dienen. In dem Doppelboden können die Versorgungsleitungen angeordnet sein. Dies erhöht auch die Sicherheit. Der Doppelboden kann optional einen oder mehr als einen Feuermelder (z.B. mindestens zwei Linien, für Alarm extern bzw. Aktivierung einer Löschgas-Anlage/Auslösung oder Löschgas-Anlage) und/oder einen Löschgas-Auslass bzw. eine Überdrucköffnung ins Freie oder innerhalb des Doppelbodens aufweisen. Optional kann der Doppelboden eine Verbindung zu einem Rauchansaugsystem bzw. einem Rauchfrüherkennungssystem für einen Voralarm und einer Abschaltung aller Lüftungsanlagen aufweisen.

Optional kann die CC-Schnittstelle als Einspeisungsschnittstelle eingerichtet sein, was eine zweiseitige Medienversorgung ermöglicht. Für eine zweiseitige Medienversorgung des FOC 102 (z.B. mit Kühlfluid und/oder Energie) können doppelt so viele Versorgungsleitungen (z.B. das doppelte der Redundanz, z.B. 2·(N+1)) vorhanden sein, was ferner die abführbare Leistung vergrößert (auf z.B. 250 kW oder mehr). Alternativ oder zusätzlich kann eine wegeredundante Versorgung von der Eispeisungsschnittstelle 412 und der CC-Schnittstelle aus ermöglicht werden, z.B. mit elektrischer Energie.

Die Versorgungsleitungen der Temperierung-Infrastruktur 114 können beispielsweise komplett durch den FOC hindurchgeführt sein und/oder Flansch- bzw. Blindflanschdeckel der Andock-Schnittstellen 722 an den Stirnseiten der FOC 102 miteinander koppeln. Absperrventile jeweils an den Stirnseiten und/oder zwischen zwei Recheneinheiten 104a, 104b können eine Redundanzumschaltung und/oder eine zweiseitige Medienversorgung ermöglichen.

Die Energieversorgung-Infrastruktur 106 kann zwei voneinander separate UV 106u und/oder voneinander separate Kabeltrassen aufweisen, um beispielsweise die Anforderungen ab Verfügbarkeitsklasse 2 (z.B. Tier 2) zu erfüllen (z.B. Versorgung mit USV-Strom A und B). Die Kabeltrassen können durchgängig durch den ganzen FOC 102 im Doppelboden hindurchgeführt werden, um beispielsweise zwei zueinander wegeredundante Versorgungspfade von den Eispeisungsschnittstellen 412 an einander gegenüberliegenden Stirnseite des FOC 102 zu ermöglichen (z.B. erste Energieversorgung links und zweite Energieversorgung rechts bei einem 40-ft-FOC). Jeder Versorgungspfad bzw. jede UV 106u kann eingerichtet sein, eine Versorgungsleistung von mindestens 250 kW (Kilowatt) oder weniger bereitzustellen. Beispielsweise kann der Querschnitt der Versorgungsleitungen jedes Versorgungspfads eingerichtet sein, die Versorgungsleistung wahlweise bei 220 V (Volt) oder auch bei 110 V bereitzustellen. Alternativ oder zusätzlich kann jeder Versorgungspfad der Energieversorgung-Infrastruktur 106 eingerichtet sein, pro 6 Meter Längserstreckung des FOC 102 eine Leistung von ungefähr 250 kW oder mehr bereitzustellen und/oder in Summe ungefähr 500 kW oder mehr (z.B. bei weniger oder keiner Redundanz) bereitzustellen.

Die Grundstromversorgung mittels der Energieversorgung-Infrastruktur 106 muss beispielsweise nicht notwendigerweise mittels einer USV abgesichert sein oder werden und/oder kann mittels eines Notstrom-Generators bereitgestellt werden. Der FOC 102 kann beispielsweise frei von einer Wärmepumpe und/oder einer USV 216 sein.

Jeder Versorgungspfad der Energieversorgung-Infrastruktur 106 kann beispielsweise mehrere (z.B. vier) Steckerleisten aufweisen und/oder drei Stromphasen separiert voneinander führen und/oder absichern. Jede der Steckerleisten kann optional eingerichtet sein, mittels eines automatischen Transferschalters, im Fall des Ausfalls eines der Energie-Versorgungspfade auf den anderen umzuschalten. Damit können Komponenten der Rechenanlage 104, die nicht zwei Netzteile aufweisen, ausfallsicher versorgt werden.

Jeder Energie-Versorgungspfad (z.B. dessen Steckerleiste) kann optional mit der Telekommunikation-Infrastruktur 914 gekoppelt sein und/oder ein Fernzugriff-Protokoll implementieren, welches eingerichtet ist, den Energie-Versorgungspfad mittels der Telekommunikation (z.B. einem Netzwerk und/oder Internet) zu steuern und/oder auszulesen. Damit können beispielsweise Temperatur und/oder Leistung ausgelesen werden. Das Fernzugriff-Protokoll kann alternativ oder zusätzlich ein serielles An- und/oder Ausschalten der Steckerleisten implementieren. Dies verhindert zu starke elektromagnetische Felder.

Optional können die Versorgungspfade 702l des oder jedes Paars zueinander redundanter Versorgungspfade 702l (z.B. der Energieversorgung-Infrastruktur und/oder der Telekommunikation-Infrastruktur) auf einander gegenüberliegenden Seiten (z.B. den Längsseiten) des FOC 102 angeordnet sein (z.B. zwischen diesen kann die Rechenanlage angeordnet sein). Damit kann beispielsweise eine Verfügbarkeitsklasse 3 oder 4 erreicht werden.

Optional kann der FOC 102 eingerichtet sein, mittels der CC-Schnittstelle 402 eine Spiegelung der Daten der Rechenanlage 104 auf einen anderen FOC des oder eines anderen Rechenzentrum-Moduls 151 bereitzustellen.

Ferner kann der FOC 102 eine Feuerlöschvorrichtung aufweisen, welche den Anforderungen der Vorzertifizierung genügt. Beispielsweise kann eine Feuerlöschflasche in jedem FOC 102 angeordnet sein, was beispielsweise einer Verfügbarkeitsklasse 1 genügen kann. Für eine Verfügbarkeitsklasse 2 oder mehr kann eine Feuerlöschvorrichtung des FOC 102 ein Feuerfrühwarnsystem (z.B. einen Rauch- oder Hitzedetektor aufweisend) aufweisen und/oder automatisch bei Erfassung eines Feuers dem Inneren des FOC 102 ein Löschmittel (z.B. das Löschgas) anfordern und/oder zuführen. Optional kann die Feuerlöschvorrichtung des FOC 102 eingerichtet sein, ein gemäß der Vorzertifizierung vorgegebenes Volumen an Löschmittel (z.B. Gas) zuzuführen und/oder eine Löschung innerhalb einer gemäß der Vorzertifizierung vorgegebenen Zeit bereitzustellen. Das Feuerfrühwarnsystem kann beispielsweise eingerichtet sein, Luft aus dem Doppelboden und/oder den UV 106u und den Rechenanlagen 104 anzusaugen und auf das Vorhandensein von Rauchpartikeln hin zu überprüfen.

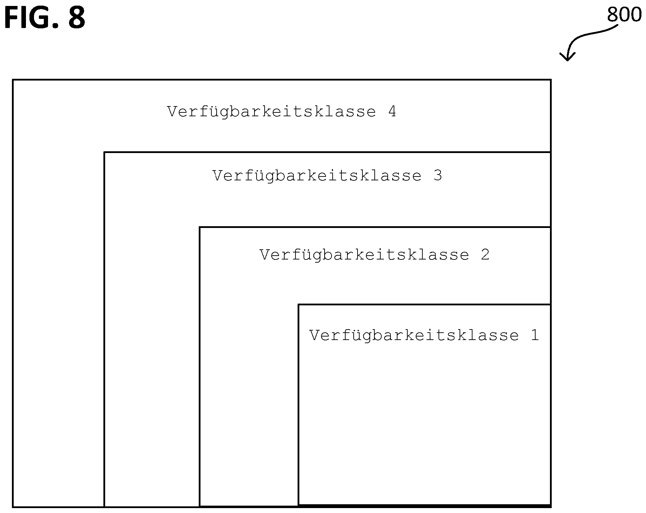

**Fig.8** veranschaulicht mehrere Verfügbarkeitsklassen gemäß verschiedenen Ausführungsformen in einem schematischen Diagramm 800. Jede der Verfügbarkeitsklassen 1 bis 4 kann Anforderungen an die Infrastruktur 702 (z.B. die Energieversorgung-Infrastruktur, die Temperierung-Infrastruktur und/oder die Telekommunikation-Infrastruktur) des FOC stellen, welche von jedem FOC 102 des Rechenzentrum-Moduls 151 einzeln erfüllt werden, so dass dieser auch vorzertifiziert sein oder werden kann, wenn z.B. auch die entsprechenden bautechnischen und sicherheitstechnischen Anforderungen erfüllt werden. Die Verfügbarkeitsklasse x+1 kann zumindest die Anforderungen der Verfügbarkeitsklasse x (x = 1 bis 3) aufweisen.

Gemäß der Verfügbarkeitsklasse 1 kann: die Energieversorgung-Infrastruktur zumindest einen Versorgungspfad (auch als Energie-Versorgungspfad bezeichnet) und die Telekommunikation-Infrastruktur zumindest einen Versorgungspfad (auch als Telekommunikation-Versorgungspfad bezeichnet), z.B. mit direkten Verbindungen und ohne Redundanzen in den Versorgungswegen und deren Komponenten, aufweisen.

Gemäß der Verfügbarkeitsklasse 2 kann: der zumindest eine Energie-Versorgungspfad zumindest ein Paar zueinander redundante Komponenten (z.B. Steckerleisten und/oder UV) aufweisen, der zumindest eine Telekommunikation-Versorgungspfad fest installiert sein, und die Temperierung-Infrastruktur zumindest einen Versorgungspfad (auch als Temperierung-Versorgungspfad bezeichnet) aufweisen. Gemäß der Verfügbarkeitsklasse 2 kann optional: der Telekommunikation-Versorgungspfad zumindest zwei Telekommunikation-Einspeisungsanschlüsse aufweisen, der Containerboden (z.B. Doppelboden) einen Standsicherheitsnachweis (auch als Statiknachweis bezeichnet) aufweisen, die Klimageräte und/oder Wärmepumpen der Temperierung-Infrastruktur doppelt vorhanden sein, die Temperierung-Infrastruktur ein vollautomatisches Umschalten auf eine externe Kaltwasserversorgung (d.h. einen zusätzlichen Kaltwasseranschluss) implementieren, und/oder die Wärmetauscher zur Wasserkühlung außerhalb des FOC angeordnet sein.

Gemäß der Verfügbarkeitsklasse 3 kann: die Energieversorgung-Infrastruktur zumindest zwei Versorgungspfade aufweisen, von denen jeder Versorgungspfad optional zumindest ein Paar zueinander redundante Komponenten aufweisen (oder jede Komponente Teil eines Paar zueinander redundante Komponenten sein) kann, die Telekommunikation-Infrastruktur mehrere fest installierte Versorgungspfade aufweisen, von denen zumindest ein Paar zueinander redundant eingerichtet ist, und der Temperierung-Versorgungspfad zumindest ein Paar redundanter Komponenten aufweisen. Gemäß der Verfügbarkeitsklasse 3 kann optional: jede Infrastruktur (d.h. die Energieversorgung-Infrastruktur, die Telekommunikation-Infrastruktur und die Temperierung-Infrastruktur) zumindest ein Paar zueinander redundante Versorgungspfade aufweisen, die Energieversorgung-Infrastruktur zumindest ein Paar zueinander redundante UV 106u aufweisen, der FOC ein Feuerfrühwarnsystem aufweisen, der FOC 102 eine Feuerlöschvorrichtung (z.B. mittels Gas) aufweisen, zumindest eine (z.B. jede) Personentür 712t des FOC 102 als Sicherheitstür eingerichtet sein.

Gemäß der Verfügbarkeitsklasse 4 kann: die Energieversorgung-Infrastruktur zumindest zwei Versorgungspfade aufweisen, von denen jeder Versorgungspfad vollständig wartungstolerant eingerichtet ist, die Telekommunikation-Infrastruktur mehrere fest installierte Versorgungspfade aufweisen, deren Versorgungsleitungen auf verschiedenen Seiten des FOC angeordnet sind, und die Temperierung-Infrastruktur mehrere Versorgungspfade aufweisen, deren Versorgungsleitungen auf verschiedenen Seiten des FOC angeordnet sind.

Gemäß der Verfügbarkeitsklasse 3 kann die Rechenanlage optional ein oder mehr als ein Paar zueinander redundante Recheneinheiten 104a, 104b aufweisen.

Die Anforderungen an die Verfügbarkeitsklasse(n) kann beispielsweise gemäß DIN EN 50600 definiert sein.

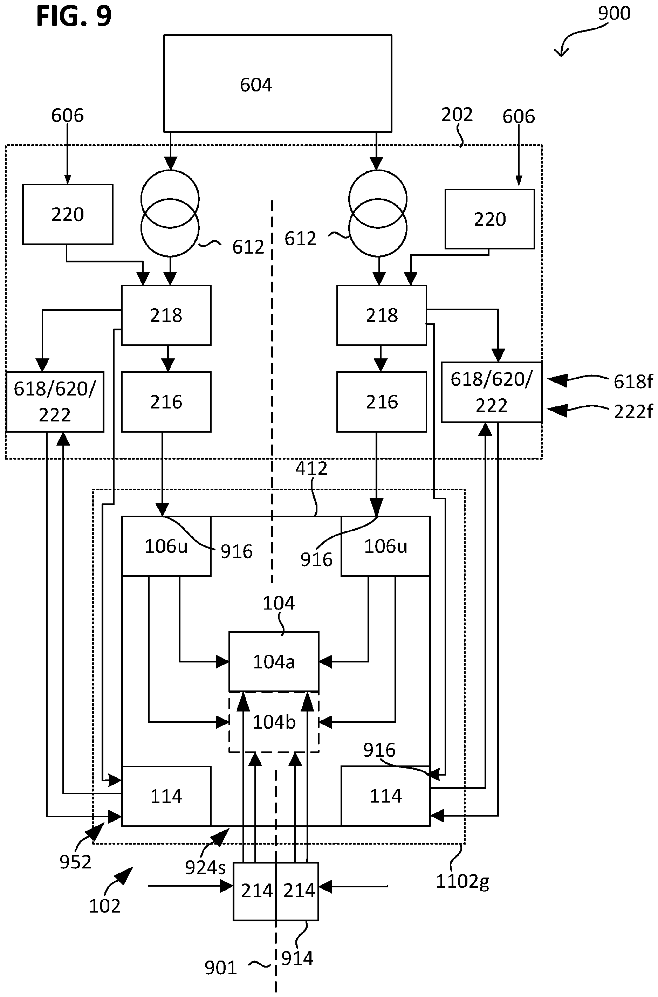

**Fig.9** veranschaulicht eine Versorgungskette 900 gemäß verschiedenen Ausführungsformen in einem schematischen Versorgungsdiagram mit schematischer Redundanzpaarung 901. Die Versorgungskette 900 kann die Versorgungsmodulanordnung 202 und den FOC 102 aufweisen. Die Versorgungskette 900 kann beispielsweise eingerichtet sein, wie die Versorgungskette 200 oder 300. Der FOC 102 kann aber auch ohne die Versorgungsmodulanordnung 202 bereitgestellt sein oder werden. Die Einspeisungsschnittstelle 412 kann innerhalb des Gehäuses 1102g des FOC 102 (auch als Containergehäuse 1102g bezeichnet) angeordnet sein.

Die Temperierung-Infrastruktur 114 (z.B. die Luftklimatisierung 104l aufweisend) kann zumindest ein Paar zueinander redundante Versorgungspfade aufweisen, von denen jeder Versorgungspfad einen Warmwasser- und/oder Kaltwasseranschluss 952 (z.B. Flansche) an der Einspeisungsschnittstelle 412 aufweist. Die Energieversorgung-Infrastruktur 106 kann zumindest ein Paar zueinander redundante Versorgungspfade aufweisen, von denen jeder Versorgungspfad zumindest eine UV 106u und/oder zumindest einen Stromeinspeisungsanschluss 916 an der Einspeisungsschnittstelle 412 aufweist. Die Telekommunikation-Infrastruktur 914 kann zumindest ein Paar zueinander redundante Versorgungspfade aufweisen, von denen jeder Versorgungspfad zumindest eine Netzwerkleitung und/oder einen Netzwerkanschluss an der Einspeisungsschnittstelle 412 aufweist (z.B. mittels Telekommunikationsschnittstelle 924s). Jede Recheneinheit 104a, 104b der Rechenanlage 104 kann optional mit jedem Paar zueinander redundanter Versorgungspfade der Telekommunikation-Infrastruktur 914, der Energieversorgung-Infrastruktur 106 und/oder der Temperierung-Infrastruktur 114 gekoppelt sein.

Diese Versorgungskette 900 kann beispielsweise dem Aufbau eines Rechenzentrums der Verfügbarkeitsklasse 3 entsprechen, dessen Teil der oder die FOC 102 ist/sind.

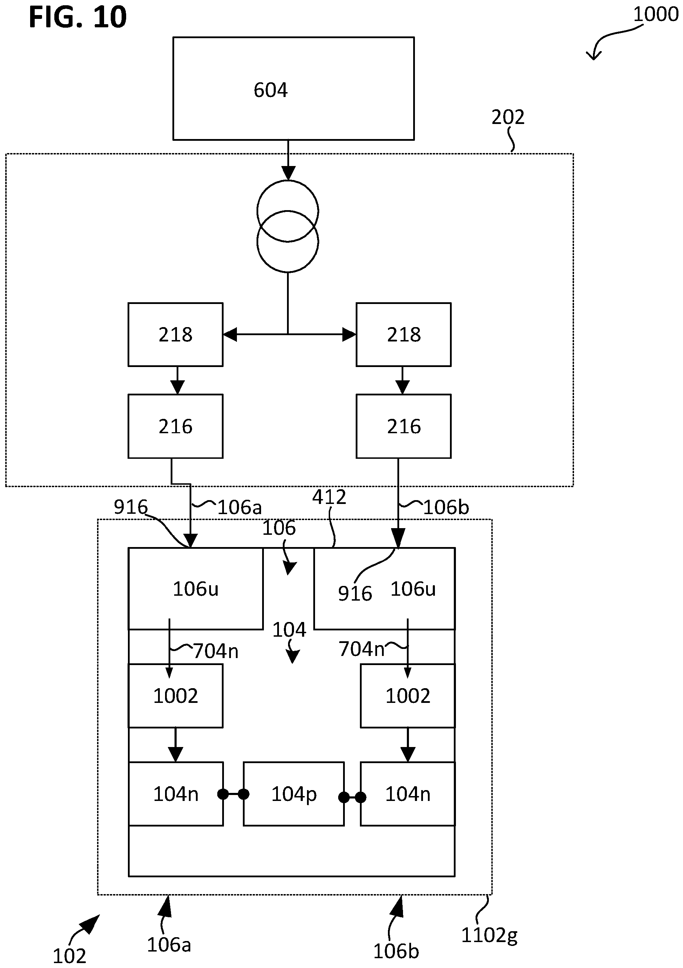

**Fig.10** veranschaulicht eine Versorgungskette 1000 gemäß verschiedenen Ausführungsformen in einem schematischen Versorgungsdiagram. Die Versorgungskette 1000 kann beispielsweise eingerichtet sein, wie die Versorgungskette 200, 300 oder 900. Der FOC 102 kann auch ohne die Versorgungsmodulanordnung 202 bereitgestellt sein oder werden.

Die Energieversorgung-Infrastruktur 106 kann zumindest ein Paar zueinander redundante Energie-Versorgungspfade aufweisen, z.B. einen ersten Energie-Versorgungspfad 106a (auch als Versorgungspfad A bezeichnet) und einen dazu redundanten zweiten Energie-Versorgungspfad 106b (auch als Versorgungspfad B bezeichnet), von denen jeder Energie-Versorgungspfad eine UV 106u aufweisen kann und mit einem Netzteil 104n der Rechenanlage gekoppelt sein kann. Die Netzteile 104n können zueinander redundant und/oder eingerichtet sein, die Prozessoren 104p (oder Rechenanlagen) mit elektrischer Energie zu versorgen. Die oder jede UV 106u (auch als tertiäre Verteilungsvorrichtung 106u oder Tertiärverteilung bezeichnet) kann eine oder mehr als eine geschützte Steckdose 1002 aufweisen (z.B. in Form einer Steckerleiste, auch Power Distribution Unit bzw. PDU genannt). Jede der Steckdosen 1002 kann mit einem der zwei zueinander redundanten Netzteilen 104n der Rechenanlage 104 gekoppelt sein.

Der tertiäre Verteilungsvorrichtung 106u kann anschaulich als horizontale Verteilungsverkabelung, also die Verteilung der zugeführten Energie innerhalb eines FOC 102 (auch als Etagenverkabelung bezeichnet) auf verschiedene Untersysteme verstanden werden.

Die Stromverteilung in dem FOC 102 (Tertiärverteilung) für eine Verfügbarkeitsklasse 3 kann beispielsweise gleich sein zu der Verfügbarkeitsklasse 2 und/oder der Verfügbarkeitsklasse 4. Gemäß der Verfügbarkeitsklasse 3 kann der FOC 102 ein Paar Stromeinspeisungsanschlüsse 916 (A und B) aufweisen und/oder ein Paar Elektro-UV 106u (Tertiärverteilung), zwischen denen jeweils umgeschaltet werden kann (z.B. mittels eines Transferschalters).

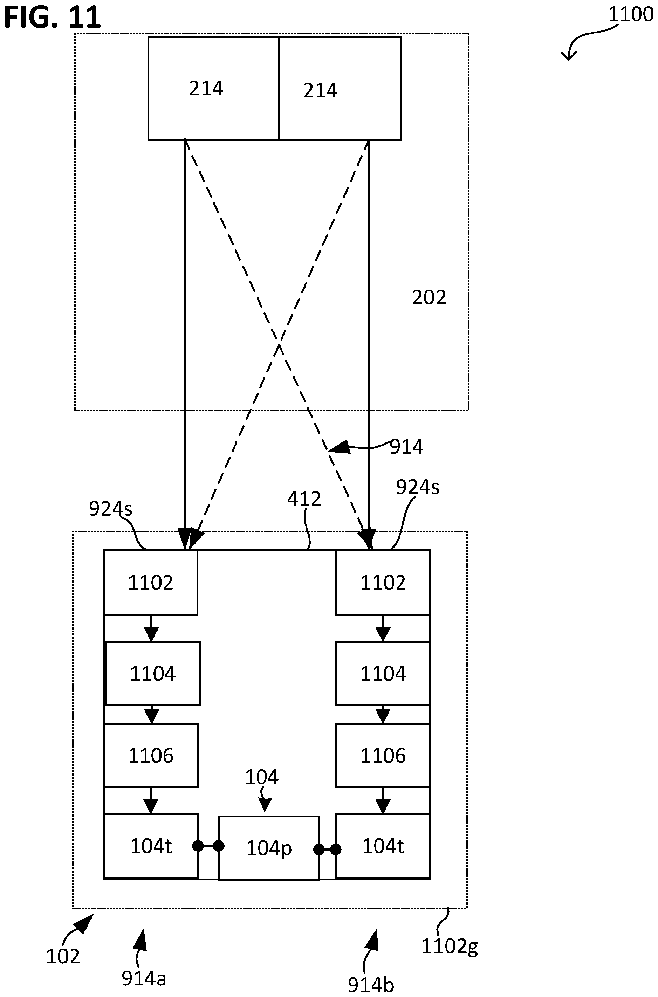

**Fig.11** veranschaulicht eine Versorgungskette 1100 gemäß verschiedenen Ausführungsformen in einem schematischen Versorgungsdiagram. Die Versorgungskette 1100 kann beispielsweise eingerichtet sein, wie die Versorgungskette 200, 300, 900 oder 1000. Der FOC 102 kann auch ohne die Versorgungsmodulanordnung 202 bereitgestellt sein oder werden.

Die Telekommunikation-Infrastruktur 914 kann zumindest ein Paar zueinander redundante Telekommunikation-Versorgungspfade aufweisen, z.B. einen ersten Telekommunikation-Versorgungspfad 914a und einen zweiten Telekommunikation-Versorgungspfad 914b, von denen jeder Telekommunikation-Versorgungspfad eine Telekommunikationsschnittstelle 924s und zumindest eine Telekommunikation-Verteilung aufweisen kann. Die zumindest eine Telekommunikation-Verteilungen kann eine Hauptverteilung 1102, eine Zwischenverteilung 1104 und/oder eine Zonenverteilung 1106 aufweisen.

Jeder der Telekommunikation-Versorgungspfade 914a, 914b kann mit einem von zwei zueinander redundanten Telekommunikationsvorrichtungen 104t der Rechenanlage 104 gekoppelt sein. Die zueinander redundanten Telekommunikationsvorrichtungen 104t können eingerichtet sein, die Prozessoren 104p (oder Rechenanlagen) mit einem Netzwerk zu verbinden und/oder Nachrichten gemäß einem Telekommunikationsprotokoll zu verarbeiten.

## Patentansprüche

1. Rechenzentrum-Modul (151), aufweisend:
mehrere Container (102), wobei jeder Container (102)
• mehrere Seitenwände (102s) aufweist, die ein Inneres des Containers (102) vollständig freilegen;
• eine Rechenanlage (104) innerhalb des Containers (102) aufweist, wobei die Rechenanlage (104) eine Vielzahl von Prozessoren (104p) aufweist;
• eine Energieversorgung-Infrastruktur (106) innerhalb des Containers (102) aufweist zum Versorgen der Rechenanlage (104) mit elektrischer Energie;
• wobei die Energieversorgung-Infrastruktur (106) eines jeden Containers (102) des Rechenzentrum-Moduls (151) hinsichtlich einer Ausfallsicherheit der Rechenanlage (104) einzeln mittels einer Verfügbarkeitsklasse, die Anforderungen an die Infrastruktur (106) der Container (102) stellt, welche von jedem Container (102) des Rechenzentrum-Moduls (151) erfüllt werden, vorzertifiziert ist,
**dadurch gekennzeichnet, dass**
jeder Container (102) eine Einspeisungsschnittstelle (412) und eine Container-zu-Container-Schnittstelle (402) aufweist, welche mittels der Energieversorgung-Infrastruktur (106) miteinander gekoppelt sind, wobei die Container-zu-Container-Schnittstelle (402) und/oder die Einspeisungsschnittstelle (412) eines jeden Containers (102) von einer Zwischenwand (102z) gehalten wird, welche zwischen einer der mehreren Seitenwände (102s) und der Rechenanlage (104) angeordnet ist.

2. Rechenzentrum-Modul (151) gemäß Anspruch 1, wobei die Energieversorgung-Infrastruktur (106) zumindest zwei Versorgungspfade aufweist.

3. Rechenzentrum-Modul (151) gemäß Anspruch 2, wobei die Energieversorgung-Infrastruktur einen Transferschalter aufweist, welcher zum Versorgen der Rechenanlage (104) zwischen den zwei Versorgungspfaden umschaltbar ist.

4. Rechenzentrum-Modul (151) gemäß einem der Ansprüche 1 bis 3, wobei die Energieversorgung-Infrastruktur (106) zumindest komponentenweise redundant ausgebildet ist.

5. Rechenzentrum-Modul (151) gemäß einem der Ansprüche 1 bis 4, wobei die Zwischenwand (102z) eine Tür (712t) aufweist.

6. Rechenzentrum-Modul (151) gemäß einem der Ansprüche 1 bis 5, wobei die mehreren Seitenwände (102s) jedes Containers (102) drei Seitenwände (102s) aufweisen.

7. Rechenzentrum-Modul (151) gemäß einem der Ansprüche 1 bis 6, wobei jede Seitenwand der mehreren Seitenwände (102s) eines jedes Containers (102) ein formschlüssig gelagertes Wandelement aufweist.

8. Rechenzentrum-Modul (151) gemäß einem der Ansprüche 1 bis 7, wobei jede Seitenwand der mehreren Seitenwände (102s) eines jedes Containers (102), die einem anderen Container (102) der mehreren Container (102) zugewandt ist, geöffnet ist.

9. Rechenzentrum-Modul (151) gemäß einem der Ansprüche 1 bis 8, wobei die mehreren Container (102) zwei, vier oder mehr Container (102) aufweisen.

10. Rechenzentrum-Modul (151) gemäß einem der Ansprüche 1 bis 9, wobei die Rechenanlage (104) eines jeden der Container zueinander redundante Prozessoren (104p) und/oder Netzteile aufweist.

11. Rechenzentrum-Modul (151) gemäß einem der Ansprüche 1 bis 10, wobei jeder Container (102) der mehreren Container (102) ein ISO-Container ist.

12. Rechenzentrum-Modul (151) gemäß einem der Ansprüche 1 bis 11, wobei für jeden Container (102):
die Rechenanlage (104) einer ersten Seitenwand der mehreren Seitenwände (102s) des Containers (102), die einem anderen Container (102) der mehreren Container (102) zugewandt ist, näher ist als eine zweite Seitenwand des Containers (102), wobei die zweite Seitenwand der ersten Seitenwand gegenüberliegt.

13. Verfahren (100) für mehrere Container (102), wobei jeder Container (102)
• mehrere Seitenwände (102s) aufweist, die ein Inneres des Containers (102) vollständig freilegen;
• eine Rechenanlage (104) innerhalb des Containers (102) aufweist, wobei die Rechenanlage (104) eine Vielzahl von Prozessoren (104p) aufweist;
• eine Energieversorgung-Infrastruktur innerhalb des Containers (102) aufweist zum Versorgen der Rechenanlage (104) mit elektrischer Energie;
• wobei die Energieversorgung-Infrastruktur eines jeden Containers (102) des Rechenzentrum-Moduls (151) hinsichtlich einer Ausfallsicherheit der Rechenanlage (104) einzeln mittels einer Verfügbarkeitsklasse, die Anforderungen an die Infrastruktur (106) der Container (102) stellt, welche von jedem Container (102) des Rechenzentrum-Moduls (151) erfüllt werden, vorzertifiziert ist,
wobei jeder Container (102) eine Einspeisungsschnittstelle (412) und eine Container-zu-Container-Schnittstelle (402) aufweist, welche mittels der Energieversorgung-Infrastruktur (106) miteinander gekoppelt sind, wobei die Container-zu-Container-Schnittstelle (402) und/oder die Einspeisungsschnittstelle (412) eines jeden Containers (102) von einer Zwischenwand (102z) gehalten wird, welche zwischen einer der mehreren Seitenwände (102s) und der Rechenanlage (104) angeordnet ist,
das Verfahren (100) aufweisend:
• Anordnen (103) der mehreren Container (102) derart relativ zueinander, dass das jeweils zwei Container (102) der mehreren Container (102) einander unmittelbar benachbart angeordnet sind; und
• für jeden der Container (102), Öffnen (105) einer der mehreren Seitenwände (102s) des Containers (102), welche einem anderen Container (102) der mehreren Container (102) zugewandt ist, wobei beim Öffnen der Seitenwand die Vorzertifizierung der Energieversorgung-Infrastruktur des Containers (102) erhalten bleibt.

## Claims

1. Computing centre module (151), having:
multiple containers (102), wherein each container (102) has
• multiple side walls (102s) which completely expose an interior of the container (102);
• a computing system (104) within the container (102), wherein the computing system (104) has a plurality of processors (104p);
• a power supply infrastructure (106) within the container (102) for supplying electrical power to the computing system (104);
• wherein the power supply infrastructure (106) of each container (102) of the computing centre module (151) is individually pre-certified with respect to a reliability of the computing system (104) by means of an availability class, which places demands on the infrastructure (106) of the containers (102), which demands are met by each container (102) of the computing centre module (151),
**characterized in that**
each container (102) has an infeed interface (412) and a container-to-container interface (402), which interfaces are coupled to one another by means of the power supply infrastructure (106), wherein the container-to-container interface (402) and/or the infeed interface (412) of each container (102) is held by an intermediate wall (102z), which is arranged between one of the multiple side walls (102s) and the computing system (104).

2. Computing centre module (151) according to Claim 1, wherein the power supply infrastructure (106) has at least two supply paths.

3. Computing centre module (151) according to Claim 2, wherein the power supply infrastructure has a transfer switch, which can be switched over between the two supply paths for supplying power to the computing system (104).

4. Computing centre module (151) according to any one of Claims 1 to 3, wherein the power supply infrastructure (106) is redundant at least in terms of components.

5. Computing centre module (151) according to any one of Claims 1 to 4, wherein the intermediate wall (102z) has a door (712t).

6. Computing centre module (151) according to any one of Claims 1 to 5, wherein the multiple side walls (102s) of each container (102) have three side walls (102s).

7. Computing centre module (151) according to any one of Claims 1 to 6, wherein each side wall of the multiple side walls (102s) of each container (102) has a form-fitted wall element.

8. Computing centre module (151) according to any one of Claims 1 to 7, wherein each side wall of the multiple side walls (102s) of each container (102) facing another container (102) of the multiple containers (102) is open.

9. Computing centre module (151) according to any one of Claims 1 to 8, wherein the multiple containers (102) have two, four or more containers (102).

10. Computing centre module (151) according to any one of Claims 1 to 9, wherein the computing system (104) of each of the containers comprises mutually redundant processors (104p) and/or power supplies.

11. Computing centre module (151) according to any one of Claims 1 to 10, wherein each container (102) of the multiple containers (102) is an ISO container.

12. Computing centre module (151) according to any one of Claims 1 to 11, wherein, for each container (102):
the computing system (104) is closer to a first side wall of the multiple side walls (102s) of the container (102) facing another container (102) of the multiple containers (102) than to a second side wall of the container (102), wherein the second side wall is opposite the first side wall.

13. Method (100) for multiple containers (102), wherein each container (102) has
• multiple side walls (102s) which completely expose an interior of the container (102);
• a computing system (104) within the container (102), wherein the computing system (104) has a plurality of processors (104p);
• a power supply infrastructure within the container (102) for supplying electrical power to the computing system (104);
• wherein the power supply infrastructure of each container (102) of the computing centre module (151) is individually pre-certified with respect to a reliability of the computing system (104) by means of an availability class, which places demands on the infrastructure (106) of the containers (102), which demands are fulfilled by each container (102) of the computing centre module (151),
wherein each container (102) has an infeed interface (412) and a container-to-container interface (402), which interfaces are coupled to one another by means of the power supply infrastructure (106), wherein the container-to-container interface (402) and/or the infeed interface (412) of each container (102) is held by an intermediate wall (102z), which is arranged between one of the multiple side walls (102s) and the computing system (104),
the method (100) comprising:
• arranging (103) the multiple containers (102) relative to one another such that in each case two containers (102) of the multiple containers (102) are arranged immediately adjacent to one another; and
• for each of the containers (102), opening (105) one of the multiple side walls (102s) of the container (102) facing another container (102) of the multiple containers (102), wherein, when the side wall is opened, the pre-certification of the power supply infrastructure of the container (102) is maintained.

## Revendications

1. Module de centre de calcul (151), présentant :
plusieurs conteneurs (102), chaque conteneur (102) présentant
• plusieurs parois latérales (102s) qui exposent complètement un espace intérieur du conteneur (102) ;
• une installation informatique (104) à l'intérieur du conteneur (102), l'installation informatique (104) présentant une pluralité de processeurs (104p) ;
• une infrastructure d'alimentation en énergie (106) à l'intérieur du conteneur (102) pour alimenter l'installation informatique (104) en énergie électrique ;
• dans lequel l'infrastructure d'alimentation en énergie (106) de chaque conteneur (102) du module de centre de calcul (151) est précertifiée en termes de fiabilité de l'installation informatique (104) individuellement au moyen d'une classe de disponibilité qui formule des exigences au niveau de l'infrastructure (106) des conteneurs (102) qui sont satisfaites par chaque conteneur (102) du module de centre de calcul (151),
**caractérisé en ce que**
chaque conteneur (102) présente une interface d'injection (412) et une interface de conteneur à conteneur (402) qui sont couplées l'une à l'autre au moyen de l'infrastructure **d'alimentation** en énergie (106), dans lequel l'interface de conteneur à conteneur (402) et/ou l'interface d'injection (412) de chaque conteneur (102) sont retenues par une paroi intermédiaire (102z) qui est disposée entre l'une des plusieurs parois latérales (102s) et l'installation informatique (104).

2. Module de centre de calcul (151) selon la revendication 1, dans lequel l'infrastructure d'alimentation en énergie (106) présente au moins deux chemins d'alimentation.

3. Module de centre de calcul (151) selon la revendication 2, dans lequel l'infrastructure d'alimentation en énergie présente un commutateur de transfert qui peut être commuté entre les deux chemins d'alimentation pour alimenter l'installation informatique (104).

4. Module de centre de calcul (151) selon l'une quelconque des revendications 1 à 3, dans lequel l'infrastructure d'alimentation en énergie (106) est réalisée de manière redondante au moins au niveau des composants.

5. Module de centre de calcul (151) selon l'une quelconque des revendications 1 à 4, dans lequel la paroi intermédiaire (102z) présente une porte (712t).

6. Module de centre de calcul (151) selon l'une quelconque des revendications 1 à 5, dans lequel les plusieurs parois latérales (102s) de chaque conteneur (102) présentent trois parois latérales (102s).

7. Module de centre de calcul (151) selon l'une quelconque des revendications 1 à 6, dans lequel chaque paroi latérale des plusieurs parois latérales (102s) de chaque conteneur (102) présente un élément de paroi monté par complémentarité de forme.

8. Module de centre de calcul (151) selon l'une quelconque des revendications 1 à 7, dans lequel chaque paroi latérale des plusieurs parois latérales (102s) de chaque conteneur (102), qui est tournée vers un autre conteneur (102) des plusieurs conteneurs (102), est ouverte.

9. Module de centre de calcul (151) selon l'une quelconque des revendications 1 à 8, dans lequel les plusieurs conteneurs (102) présentent deux, quatre ou plusieurs conteneurs (102).

10. Module de centre de calcul (151) selon l'une quelconque des revendications 1 à 9, dans lequel l'installation informatique (104) de chacun des conteneurs présente des processeurs (104p) ou des blocs d'alimentation redondants entre eux.

11. Module de centre de calcul (151) selon l'une quelconque des revendications 1 à 10, dans lequel chaque conteneur (102) des plusieurs conteneurs (102) est un conteneur ISO.

12. Module de centre de calcul (151) selon l'une quelconque des revendications 1 à 11, dans lequel pour chaque conteneur (102) :
l'installation informatique (104) d'une première paroi latérale des plusieurs parois latérales (102s) du conteneur (102), qui est tournée vers un autre conteneur (102) des plusieurs conteneurs (102), est plus proche qu'une deuxième paroi latérale du conteneur (102), la deuxième paroi latérale étant en face de la première paroi latérale.

13. Procédé (100) pour plusieurs conteneurs (102), chaque conteneur (102) présentant
• plusieurs parois latérales (102s) qui exposent complètement un espace intérieur du conteneur (102) ;
• une installation informatique (104) à l'intérieur du conteneur (102), l'installation informatique (104) présentant une pluralité de processeurs (104p) ;
• une infrastructure d'alimentation en énergie à l'intérieur du conteneur (102) pour alimenter l'installation informatique (104) en énergie électrique ;
• dans lequel l'infrastructure d'alimentation en énergie de chaque conteneur (102) du module de centre de calcul (151) est précertifiée en termes de fiabilité de l'installation informatique (104) individuellement au moyen d'une classe de disponibilité qui formule des exigences au niveau de l'infrastructure (106) des conteneurs (102) qui sont satisfaites par chaque conteneur (102) du module de centre de calcul (151),
dans lequel chaque conteneur (102) présente une interface d'injection (412) et une interface de conteneur à conteneur (402) qui sont couplées l'une à l'autre au moyen de l'infrastructure d'alimentation en énergie (106), dans lequel l'interface de conteneur à conteneur (402) et/ou l'interface d'injection (412) de chaque conteneur (102) sont retenues par une paroi intermédiaire (102z) qui est disposée entre l'une des plusieurs parois latérales (102s) et l'installation informatique (104),
le procédé (100) présentant les étapes consistant à :
• disposer (103) les plusieurs conteneurs (102) les uns par rapport aux autres de telle sorte que respectivement deux conteneurs (102) des plusieurs conteneurs (102) sont disposés de manière directement adjacente l'un à l'autre ; et
• pour chacun des conteneurs (102), ouvrir (105) une des plusieurs parois latérales (102s) du conteneur (102) qui est tournée vers un autre conteneur (102) des plusieurs conteneurs (102), dans lequel à l'ouverture de la paroi latérale la précertification de l'infrastructure d'alimentation en énergie du conteneur (102) est préservée.
